# EUROPEAN PATENT APPLICATION

(11) **EP 4 498 161 A1**
(43) Date of publication of application: **29.01.2025**
(21) Application number: 23187274.8
(22) Date of filing: 24.07.2023
(51) Int. Cl.: G03F 7/20

(54) **SYSTEM AND METHOD FOR IN-SITU CLEANING A CLAMP OF A LITHOGRAPHY APPARATUS BY OSCILLATORY MOVEMENT OF A CLEANING BODY**

(71) Applicant: ASML Netherlands B.V., 5500 AH Veldhoven (NL)
(72) Inventor: JOCHEMSEN, Marinus, 5500AH Veldhoven (NL); MARKS, Michiel, Franciscus, Monica, 5500 AH Veldhoven (NL)
(74) Representative: ASML Netherlands B.V.

(57) **Abstract**

Disclosed herein is a system for in-situ cleaning of a clamp of a lithography apparatus, the system comprising: a body configured to be inserted into the lithography apparatus and engaged with a clamp, wherein cleaning features are arranged on a clamp facing surface of the body; a movement system of the clamp; and a control system; wherein the control system is configured to: control the clamp to use a first clamping force to engage the body with the clamp; control the movement system to move the clamp in an oscillatory movement with the first clamping force applied, wherein the first clamping force substantially prevents relative movement between the cleaning features and the clamp; and control the clamp to change the clamping force from the first clamping force to a second clamping force, wherein the second clamping force is weaker than the first clamping force, so that relative movement between the cleaning features and the clamp occurs in response to the oscillatory movement.

## Description

### TECHNICAL FIELD

The description herein relates generally to systems and methods for cleaning a portion of a lithography apparatus.

### BACKGROUND

A lithography (e.g., projection) apparatus can be used, for example, in the manufacture of integrated circuits (ICs). In such a case, a patterning device (e.g., a mask) may contain or provide a pattern corresponding to an individual layer of the IC ("design layout"), and this pattern can be transferred onto a target portion (e.g. comprising one or more dies) on a substrate (e.g., silicon wafer) that has been coated with a layer of radiation-sensitive material ("resist"), by methods such as irradiating the target portion through the pattern on the patterning device. In general, a single substrate contains a plurality of adjacent target portions to which the pattern is transferred successively by the lithographic projection apparatus, one target portion at a time. In one type of lithographic projection apparatus, the pattern on the entire patterning device is transferred onto one target portion in one operation. Such an apparatus is commonly referred to as a stepper. In an alternative apparatus, commonly referred to as a step-and-scan apparatus, a projection beam scans over the patterning device in a given reference direction (the "scanning" direction) while synchronously moving the substrate parallel or anti-parallel to this reference direction. Different portions of the pattern on the patterning device are transferred to one target portion progressively. Since, in general, the lithographic projection apparatus will have a reduction ratio M (e.g., 4), the speed F at which the substrate is moved will be 11M times that at which the projection beam scans the patterning device. More information with regard to lithographic devices as described herein can be gleaned, for example, from US 6,046,792, incorporated herein by reference.

### SUMMARY

A cleaning system is described. The cleaning system comprises a body that is configured to be inserted into a lithography apparatus, engaged by a tool handler of the lithography apparatus, and used for cleaning a clamp of the lithography apparatus. Locations and dimensions of cleaning features on a clamp facing surface of the body approximate locations and dimensions of contamination particles on the clamp. Compared to prior approaches, the described system is better able to eliminate particle contamination from the clamp; requires less time for cleaning; does not require breaking vacuum, opening, or other disassembly of the lithography apparatus; prevents potential damage of the clamps due to mishandling of other cleaning apparatus; and has other advantages.

According to a first aspect of the invention, there is provided a system for in-situ cleaning of a clamp of a lithography apparatus, the system comprising: a body configured to be inserted into the lithography apparatus and engaged with a clamp, wherein cleaning features are arranged on a clamp facing surface of the body; a movement system of the clamp; and a control system; wherein the control system is configured to: control the clamp to use a first clamping force to engage the body with the clamp; control the movement system to move the clamp in an oscillatory movement with the first clamping force applied, wherein the first clamping force substantially prevents relative movement between the cleaning features and the clamp; and control the clamp to change the clamping force from the first clamping force to a second clamping force, wherein the second clamping force is weaker than the first clamping force, so that relative movement between the cleaning features and the clamp occurs in response to the oscillatory movement.

According to a second aspect of the invention, there is provided a lithographic apparatus comprising the system according to the first aspect.

According to a third aspect of the invention, there is provided a method for in-situ cleaning of a clamp of a lithography apparatus, the method comprising: inserting a body into the lithography apparatus, the body comprising cleaning features disposed on a clamp engaging surface of the body; using a first clamping force to engage the body with the clamp; performing an oscillatory movement of the clamp with the first clamping force applied, wherein the first clamping force substantially prevents relative movement between the cleaning features and the clamp; and changing the clamping force from the first clamping force to a second clamping force, wherein the second clamping force is weaker than the first clamping force, so that relative movement between the cleaning features and the clamp occurs in response to the oscillatory movement.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Fig. 1 schematically depicts a lithography apparatus, according to an embodiment.
Fig. 2 schematically depicts an embodiment of a lithographic cell or cluster, according to an embodiment.
Fig. 3A illustrates a portion of an extreme ultra violet (EUV) lithographic apparatus, according to an embodiment.
Fig. 3B illustrates a portion of a deep ultra violet (DUV) lithographic apparatus, according to an embodiment.
Fig. 3C is an enlarged view of a portion of the lithographic apparatus shown in Fig. 3B, according to an embodiment.
Fig. 4 illustrates examples of contamination particles on a reticle clamp, according to an embodiment.
Fig. 5 illustrates dimensional information about typical contamination particles, according to an embodiment.
Fig. 6 illustrates an example of the present cleaning system, according to an embodiment.
Fig. 7 illustrates how the locations of cleaning features of the cleaning system alternate with gripping areas on a clamp facing surface of the body of the cleaning system in a macro pattern across an entirety of a clamp facing surface of the body, according to an embodiment.
Fig. 8 illustrates a method for cleaning a clamp of a lithography apparatus, according to an embodiment.
Fig. 9 is a block diagram of an example computer system, according to an embodiment.
Fig. 10 is a schematic diagram of a lithographic projection apparatus similar to Fig. 1, according to an embodiment.

### DETAILED DESCRIPTION

In general, a mask or reticle may be a transparent block of material that is covered with a pattern defined by a different, opaque material. Various masks are fed into a lithographic apparatus and used to form layers of a semiconductor device. The pattern defined on a given mask or reticle corresponds to features produced in one or more layers of the semiconductor device. Often, a plurality of masks or reticles are automatically fed into a lithographic apparatus during manufacturing and used to form corresponding layers of a semiconductor device. A clamp (e.g., an electrostatic reticle clamp) in the lithographic apparatus is used to secure a masks or reticles during processing. This clamp may become contaminated with particles of material transferred from reticles causing performance degradation over time, and requiring periodic cleaning to restore performance.

Cleaning these clamps can require stopping the lithographic apparatus and the manufacturing process. This cleaning can require several hours to complete, expose the environment inside the lithographic apparatus to ambient conditions, may introduce other contaminants into the system, and/or have other disadvantages. In addition, even if some prior cleaning methods are able to be performed without exposing the environment inside the lithographic apparatus to ambient conditions, the prior cleaning methods generally are not able to adequately remove relatively small (e.g., up to approximately 5µm wide × 200nm thick) particle contamination from the clamps.

In contrast, the present systems and methods provide a cleaning system configured to be used to clean the clamps of a lithographic apparatus, including cleaning relatively small contamination particles. The cleaning system is configured to be automatically inserted into, and handled by, the lithographic apparatus just as any other mask or reticle is automatically inserted into, and handled by, the lithographic apparatus. Cleaning features are disposed (e.g. patterned) on a clamp facing surface of a system body. Locations and dimensions of the cleaning features on the clamp facing surface approximate locations and dimensions of the contamination particles on a clamp, such that relative movement between the cleaning features and the clamp cleans the contamination particles from the clamp. For example, the locations of the cleaning features on the clamp facing surface correspond to reticle contact areas (e.g., burls) on the clamp where the contamination particles are located. The dimensions of the cleaning features comprise a specific shape, pitch, line width, thickness, and/or other dimensions. The cleaning is performed in-situ, while the lithographic apparatus continues to operate. Cleaning the clamps of the lithographic apparatus with the present cleaning system can also save hours of downtime associated with prior inspection and cleaning methods, avoid exposing an environment inside the lithographic apparatus to ambient conditions (e.g., avoid breaking system vacuum), avoid contaminating the clamps with other outside contamination, avoid damaging the clamp due to mishandling of a manual cleaning apparatus, and/or have other advantages.

Although specific reference may be made in this text to the manufacture of integrated circuits (ICs), it should be understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as interchangeable with the more general terms "mask", "substrate" and "target portion", respectively. In addition, any use of the terms "reticle" or "mask" herein may be considered synonymous with the more general term "patterning device."

As an introduction, prior to transferring a pattern from a patterning device such as a mask to a substrate, the substrate may undergo various procedures, such as priming, resist coating and a soft bake. After exposure, the substrate may be subjected to other procedures ("post-exposure procedures"), such as a post-exposure bake (PEB), development, a hard bake and measurement and/or other inspection of the transferred pattern. This array of procedures is used as a basis to make an individual layer of a device, e.g., an IC. The substrate may then undergo various processes such as etching, ion-implantation (doping), metallization, oxidation, chemical mechanical polishing, etc., all intended to finish an individual layer of the device. If several layers are required in the device, then the whole procedure, or a variant thereof, is repeated for each layer. Eventually, a device will be present in each target portion on the substrate. These devices are then separated from one another by a technique such as dicing or sawing, whence the individual devices can be mounted on a carrier, connected to pins, etc.

Manufacturing devices, such as semiconductor devices, typically involves processing a substrate (e.g., a semiconductor wafer) using a number of fabrication processes to form various features and multiple layers of the devices. Such layers and features are typically manufactured and processed using, e.g., deposition, lithography, etch, chemical mechanical polishing, ion implantation, and/or other processes. Multiple devices may be fabricated on a plurality of dies on a substrate and then separated into individual devices. This device manufacturing process may be considered a patterning process. A patterning process involves a patterning step, such as optical and/or nanoimprint lithography using a patterning device in a lithographic apparatus, to transfer a pattern on the patterning device to a substrate and typically, but optionally, involves one or more related pattern processing steps, such as resist development by a development apparatus, baking of the substrate using a bake tool, etching using the pattern using an etch apparatus, etc. One or more metrology processes are typically involved in the patterning process.

Lithography is a step in the manufacturing of device such as ICs, where patterns formed on substrates define functional elements of the devices, such as microprocessors, memory chips, etc. Similar lithographic techniques are also used in the formation of flat panel displays, micro-electro mechanical systems (MEMS) and other devices.

As semiconductor manufacturing processes continue to advance, the dimensions of functional elements have continually been reduced while the number of functional elements, such as transistors, per device has been steadily increasing over decades, following a trend commonly referred to as "Moore's law". At the current state of technology, layers of devices are manufactured using lithographic projection apparatuses that project a design layout onto a substrate using illumination from a deep-ultraviolet illumination source, creating individual functional elements having dimensions well below 100 nm, i.e. less than half the wavelength of the radiation from the illumination source (e.g., a 193 nm illumination source).

This process in which features with dimensions smaller than the classical resolution limit of a lithographic projection apparatus are printed, is commonly known as low-k1 lithography, according to the resolution formula CD = k1×λ/NA, where λ is the wavelength of radiation employed (currently in most cases 248nm or 193nm), NA is the numerical aperture of projection optics in the lithographic projection apparatus, CD is the "critical dimension"-generally the smallest feature size printed-and k1 is an empirical resolution factor. In general, the smaller k1 the more difficult it becomes to reproduce a pattern on the substrate that resembles the shape and dimensions planned by a designer in order to achieve particular electrical functionality and performance. To overcome these difficulties, sophisticated fine-tuning steps are applied to the lithographic projection apparatus, the design layout, or the patterning device. These include, for example, but not limited to, optimization of NA and optical coherence settings, customized illumination schemes, use of phase shifting patterning devices, optical proximity correction (OPC, sometimes also referred to as "optical and process correction") in the design layout, overlay measurement, or other methods generally defined as "resolution enhancement techniques" (RET).

The term "projection optics" as used herein should be broadly interpreted as encompassing various types of optical systems, including refractive optics, reflective optics, apertures and catadioptric optics, for example. The term "projection optics" may also include components operating according to any of these design types for directing, shaping, or controlling the projection beam of radiation, collectively or singularly. The term "projection optics" may include any optical component in the lithographic projection apparatus, no matter where the optical component is located on an optical path of the lithographic projection apparatus. Projection optics may include optical components for shaping, adjusting and/or projecting radiation from the source before the radiation passes the patterning device, and/or optical components for shaping, adjusting and/or projecting the radiation after the radiation passes the patterning device. The projection optics generally exclude the source and the patterning device.

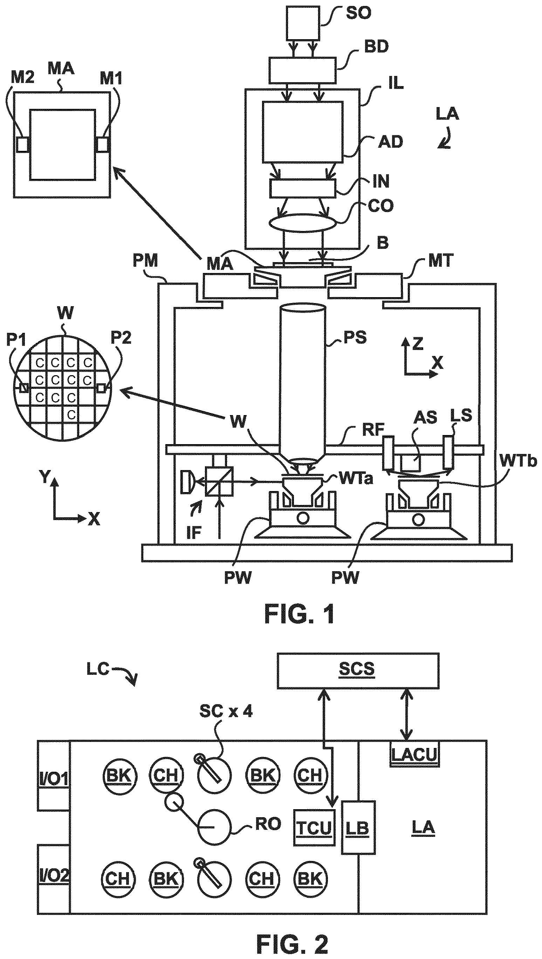

Fig. 1 schematically depicts an embodiment of a lithographic apparatus LA that may be included in and/or associated with the present systems and/or methods. The apparatus comprises: an illumination system (illuminator) IL configured to condition a radiation beam B (e.g. UV radiation, DUV radiation, or EUV radiation); a support structure (e.g. a mask table) MT constructed to support a patterning device (e.g. a mask) MA and connected to a first positioner PM configured to accurately position the patterning device in accordance with certain parameters; a substrate table (e.g. a wafer table) WT (e.g., WTa, WTb or both) configured to hold a substrate (e.g. a resist-coated wafer) W and coupled to a second positioner PW configured to accurately position the substrate in accordance with certain parameters; and a projection system (e.g. a refractive projection lens system) PS configured to project a pattern imparted to the radiation beam B by patterning device MA onto a target portion C (e.g. comprising one or more dies and often referred to as fields) of the substrate W. The projection system is supported on a reference frame (RF). As depicted, the apparatus is of a transmissive type (e.g. employing a transmissive mask). Alternatively, the apparatus may be of a reflective type (e.g. employing a programmable mirror array of a type as referred to above, or employing a reflective mask).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases, the source may be an integral part of the apparatus, for example when the source is a mercury lamp. The source SO and the illuminator IL, together with the beam delivery system BD if required, may be referred to as a radiation system.

The illuminator IL may alter the intensity distribution of the beam. The illuminator may be arranged to limit the radial extent of the radiation beam such that the intensity distribution is non-zero within an annular region in a pupil plane of the illuminator IL. Additionally or alternatively, the illuminator IL may be operable to limit the distribution of the beam in the pupil plane such that the intensity distribution is non-zero in a plurality of equally spaced sectors in the pupil plane. The intensity distribution of the radiation beam in a pupil plane of the illuminator IL may be referred to as an illumination mode.

The illuminator IL may comprise adjuster AD configured to adjust the (angular / spatial) intensity distribution of the beam. Generally, at least the outer and/or inner radial extent (commonly referred to as σ-outer and σ-inner, respectively) of the intensity distribution in a pupil plane of the illuminator can be adjusted. The illuminator IL may be operable to vary the angular distribution of the beam. For example, the illuminator may be operable to alter the number, and angular extent, of sectors in the pupil plane wherein the intensity distribution is non-zero. By adjusting the intensity distribution of the beam in the pupil plane of the illuminator, different illumination modes may be achieved. For example, by limiting the radial and angular extent of the intensity distribution in the pupil plane of the illuminator IL, the intensity distribution may have a multi-pole distribution such as, for example, a dipole, quadrupole or hexapole distribution. A desired illumination mode may be obtained, e.g., by inserting an optic which provides that illumination mode into the illuminator IL or using a spatial light modulator.

The illuminator IL may be operable to alter the polarization of the beam and may be operable to adjust the polarization using adjuster AD. The polarization state of the radiation beam across a pupil plane of the illuminator IL may be referred to as a polarization mode. The use of different polarization modes may allow greater contrast to be achieved in the image formed on the substrate W. The radiation beam may be unpolarized. Alternatively, the illuminator may be arranged to linearly polarize the radiation beam. The polarization direction of the radiation beam may vary across a pupil plane of the illuminator IL. The polarization direction of radiation may be different in different regions in the pupil plane of the illuminator IL. The polarization state of the radiation may be chosen in dependence on the illumination mode. For multi-pole illumination modes, the polarization of each pole of the radiation beam may be generally perpendicular to the position vector of that pole in the pupil plane of the illuminator IL. For example, for a dipole illumination mode, the radiation may be linearly polarized in a direction that is substantially perpendicular to a line that bisects the two opposing sectors of the dipole. The radiation beam may be polarized in one of two different orthogonal directions, which may be referred to as X-polarized and Y-polarized states. For a quadrupole illumination mode, the radiation in the sector of each pole may be linearly polarized in a direction that is substantially perpendicular to a line that bisects that sector. This polarization mode may be referred to as XY polarization. Similarly, for a hexapole illumination mode the radiation in the sector of each pole may be linearly polarized in a direction that is substantially perpendicular to a line that bisects that sector. This polarization mode may be referred to as TE polarization.

In addition, the illuminator IL generally comprises various other components, such as an integrator IN and a condenser CO. The illumination system may include various types of optical components, such as refractive, reflective, magnetic, electromagnetic, electrostatic, or other types of optical components, or any combination thereof, for directing, shaping, or controlling radiation. Thus, the illuminator provides a conditioned beam of radiation B, having a desired uniformity and intensity distribution in its cross section.

The support structure MT supports the patterning device in a manner that depends on the orientation of the patterning device, the design of the lithographic apparatus, and other conditions, such as for example whether or not the patterning device is held in a vacuum environment. The support structure may use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system.

The term "patterning device" used herein should be broadly interpreted as referring to any device that can be used to impart a pattern in a target portion of the substrate. In an embodiment, a patterning device is any device that can be used to impart a radiation beam with a pattern in its cross-section to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in a target portion of the device, such as an integrated circuit.

A patterning device may be transmissive or reflective. Examples of patterning devices include reticles or masks, programmable mirror arrays, and programmable LCD panels. Reticles or masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted to reflect an incoming radiation beam in different directions. The tilted mirrors impart a pattern in a radiation beam, which is reflected by the mirror matrix.

The term "projection system" used herein should be broadly interpreted as encompassing any type of projection system, including refractive, reflective, catadioptric, magnetic, electromagnetic, and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The projection system PS has an optical transfer function which may be non-uniform, which can affect the pattern imaged on the substrate W. For unpolarized radiation such effects can be fairly well described by two scalar maps, which describe the transmission (apodization) and relative phase (aberration) of radiation exiting the projection system PS as a function of position in a pupil plane thereof. These scalar maps, which may be referred to as the transmission map and the relative phase map, may be expressed as a linear combination of a complete set of basis functions. A convenient set is the Zernike polynomials, which form a set of orthogonal polynomials defined on a unit circle. A determination of each scalar map may involve determining the coefficients in such an expansion. Since the Zernike polynomials are orthogonal on the unit circle, the Zernike coefficients may be determined by calculating the inner product of a measured scalar map with each Zernike polynomial in turn and dividing this by the square of the norm of that Zernike polynomial.

The transmission map and the relative phase map are field and system dependent. That is, in general, each projection system PS will have a different Zernike expansion for each field point (i.e. for each spatial location in its image plane). The relative phase of the projection system PS in its pupil plane may be determined by projecting radiation, for example from a point-like source in an object plane of the projection system PS (i.e. the plane of the patterning device MA), through the projection system PS and using a shearing interferometer to measure a wavefront (i.e. a locus of points with the same phase). A shearing interferometer is a common path interferometer and therefore, advantageously, no secondary reference beam is required to measure the wavefront. The shearing interferometer may comprise a diffraction grating, for example a two dimensional grid, in an image plane of the projection system (i.e. the substrate table WTa or WTb) and a detector arranged to detect an interference pattern in a plane that is conjugate to a pupil plane of the projection system PS. The interference pattern is related to the derivative of the phase of the radiation with respect to a coordinate in the pupil plane in the shearing direction. The detector may comprise an array of sensing elements such as, for example, charge coupled devices (CCDs).

The projection system PS of a lithography apparatus may not produce visible fringes and therefore the accuracy of the determination of the wavefront can be enhanced using phase stepping techniques such as, for example, moving the diffraction grating. Stepping may be performed in the plane of the diffraction grating and in a direction perpendicular to the scanning direction of the measurement. The stepping range may be one grating period, and at least three (uniformly distributed) phase steps may be used. Thus, for example, three scanning measurements may be performed in the y-direction, each scanning measurement being performed for a different position in the x-direction. This stepping of the diffraction grating effectively transforms phase variations into intensity variations, allowing phase information to be determined. The grating may be stepped in a direction perpendicular to the diffraction grating (z direction) to calibrate the detector.

The diffraction grating may be sequentially scanned in two perpendicular directions, which may coincide with axes of a co-ordinate system of the projection system PS (x and y) or may be at an angle such as 45 degrees to these axes. Scanning may be performed over an integer number of grating periods, for example one grating period. The scanning averages out phase variation in one direction, allowing phase variation in the other direction to be reconstructed. This allows the wavefront to be determined as a function of both directions.

The transmission (apodization) of the projection system PS in its pupil plane may be determined by projecting radiation, for example from a point-like source in an object plane of the projection system PS (i.e. the plane of the patterning device MA), through the projection system PS and measuring the intensity of radiation in a plane that is conjugate to a pupil plane of the projection system PS, using a detector. The same detector as is used to measure the wavefront to determine aberrations may be used.

The projection system PS may comprise a plurality of optical (e.g., lens) elements and may further comprise an adjustment mechanism configured to adjust one or more of the optical elements to correct for aberrations (phase variations across the pupil plane throughout the field). To achieve this, the adjustment mechanism may be operable to manipulate one or more optical (e.g., lens) elements within the projection system PS in one or more different ways. The projection system may have a co-ordinate system wherein its optical axis extends in the z direction. The adjustment mechanism may be operable to do any combination of the following: displace one or more optical elements; tilt one or more optical elements; and/or deform one or more optical elements. Displacement of an optical element may be in any direction (x, y, z, or a combination thereof). Tilting of an optical element is typically out of a plane perpendicular to the optical axis, by rotating about an axis in the x and/or y directions although a rotation about the z axis may be used for a non-rotationally symmetric aspherical optical element. Deformation of an optical element may include a low frequency shape (e.g. astigmatic) and/or a high frequency shape (e.g. free form aspheres). Deformation of an optical element may be performed for example by using one or more actuators to exert force on one or more sides of the optical element and/or by using one or more heating elements to heat one or more selected regions of the optical element. In general, it may not be possible to adjust the projection system PS to correct for apodization (transmission variation across the pupil plane). The transmission map of a projection system PS may be used when designing a patterning device (e.g., mask) MA for the lithography apparatus LA. Using a computational lithography technique, the patterning device MA may be designed to at least partially correct for apodization.

The lithographic apparatus may be of a type having two (dual stage) or more tables (e.g., two or more substrate tables WTa, WTb, two or more patterning device tables, a substrate table WTa and a table WTb below the projection system without a substrate that is dedicated to, for example, facilitating measurement, and/or cleaning, etc.). In such "multiple stage" machines, the additional tables may be used in parallel, or preparatory steps may be carried out on one or more tables while one or more other tables are being used for exposure. For example, alignment measurements using an alignment sensor AS and/or level (height, tilt, etc.) measurements using a level sensor LS may be made.

The lithographic apparatus may also be of a type wherein at least a portion of the substrate may be covered by a liquid having a relatively high refractive index, e.g. water, to fill a space between the projection system and the substrate. An immersion liquid may also be applied to other spaces in the lithographic apparatus, for example, between the patterning device and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

In operation of the lithographic apparatus, a radiation beam is conditioned and provided by the illumination system IL. The radiation beam B is incident on the patterning device (e.g., mask) MA, which is held on the support structure (e.g., mask table) MT. Having traversed the patterning device MA, the radiation beam B passes through the projection system PS, which focuses the beam onto a target portion C of the substrate W. With the aid of the second positioner PW and position sensor IF (e.g., an interferometric device, linear encoder, 2-D encoder, or capacitive sensor), the substrate table WT can be moved accurately, e.g. to position different target portions C in the path of the radiation beam B. Similarly, the first positioner PM and another position sensor (which is not explicitly depicted in Fig. 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner), the support structure MT may be connected to a short-stroke actuator only, or may be fixed. Patterning device MA and substrate W may be aligned using patterning device alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device MA, the patterning device alignment marks may be located between the dies.

The depicted apparatus may be used in at least one of the following modes: 1. In step mode, the support structure MT and the substrate table WT are kept essentially stationary, while a pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure. 2. In scan mode, the support structure MT and the substrate table WT are scanned synchronously while a pattern imparted to the radiation beam is projected onto a target portion C (i.e. a single dynamic exposure). The velocity and direction of the substrate table WT relative to the support structure MT may be determined by the (de-) magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. 3. In another mode, the support structure MT is kept essentially stationary holding a programmable patterning device, and the substrate table WT is moved or scanned while a pattern imparted to the radiation beam is projected onto a target portion C. In this mode, generally a pulsed radiation source is employed, and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above. Combinations and/or variations on the above-described modes of use or entirely different modes of use may also be employed.

A substrate may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already includes multiple processed layers.

The terms "radiation" and "beam" used herein encompass all types of electromagnetic radiation, including ultraviolet (UV) or deep ultraviolet (DUV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

Various patterns on or provided by a patterning device may have different process windows. i.e., a space of processing variables under which a pattern will be produced within specification. Examples of pattern specifications that relate to potential systematic defects include checks for necking, line pull back, line thinning, critical dimension (CD), edge placement, overlapping, resist top loss, resist undercut and/or bridging. The process window of the patterns on a patterning device or an area thereof may be obtained by merging (e.g., overlapping) process windows of each individual pattern. The boundary of the process window of a group of patterns comprises boundaries of process windows of some of the individual patterns. In other words, these individual patterns limit the process window of the group of patterns. These patterns can be referred to as "hot spots" or "process window limiting patterns (PWLPs)," which are used interchangeably herein. When controlling a part of a patterning process, it is possible and economical to focus on the hot spots. When the hot spots are not defective, it is most likely that other patterns are not defective.

As shown in Fig. 2, the lithographic apparatus LA may form part of a lithographic cell LC, also sometimes referred to a lithocell or cluster, which also includes apparatuses to perform pre- and post-exposure processes on a substrate. Conventionally these include one or more spin coaters SC to deposit one or more resist layers, one or more developers to develop exposed resist, one or more chill plates CH and/or one or more bake plates BK. A substrate handler, or robot, RO picks up one or more substrates from input/output port I/O 1, I/O2, moves them between the different process apparatuses and delivers them to the loading bay LB of the lithographic apparatus. These apparatuses, which are often collectively referred to as the track, are under the control of a track control unit TCU which is itself controlled by the supervisory control system SCS, which also controls the lithographic apparatus via lithography control unit LACU. Thus, the different apparatuses can be operated to maximize throughput and processing efficiency.

In order that a substrate that is exposed by the lithographic apparatus is exposed correctly and consistently and/or in order to monitor a part of the patterning process (e.g., a device manufacturing process) that includes at least one pattern transfer step (e.g., an optical lithography step), it is desirable to inspect a substrate or other object to measure or determine one or more properties such as alignment, overlay (which can be, for example, between structures in overlying layers or between structures in a same layer that have been provided separately to the layer by, for example, a double patterning process), line thickness, critical dimension (CD), focus offset, a material property, etc. For example, contamination on reticle clamp membranes (e.g., as described herein) may adversely affect overlay because clamping a reticle over such contamination will distort the reticle. Accordingly, a manufacturing facility in which lithocell LC is located also typically includes a metrology system that measures some or all of the substrates W (Fig. 1) that have been processed in the lithocell or other objects in the lithocell. The metrology system may be part of the lithocell LC, for example it may be part of the lithographic apparatus LA (such as alignment sensor AS (Fig. 1)).

The one or more measured parameters may include, for example, alignment, overlay between successive layers formed in or on the patterned substrate, critical dimension (CD) (e.g., critical linewidth) of, for example, features formed in or on the patterned substrate, focus or focus error of an optical lithography step, dose or dose error of an optical lithography step, optical aberrations of an optical lithography step, etc. This measurement may be performed on a target of the product substrate itself and/or on a dedicated metrology target provided on the substrate. The measurement can be performed after-development of a resist but before etching, after-etching, after deposition, and/or at other times.

There are various techniques for making measurements of the structures formed in the patterning process, including the use of a scanning electron microscope, an image-based measurement tool and/or various specialized tools. As discussed above, a fast and non-invasive form of specialized metrology tool is one in which a beam of radiation is directed onto a target on the surface of the substrate and properties of the scattered (diffracted/reflected) beam are measured. By evaluating one or more properties of the radiation scattered by the substrate, one or more properties of the substrate can be determined. This may be termed diffraction-based metrology. One such application of this diffraction-based metrology is in the measurement of feature asymmetry within a target. This can be used as a measure of overlay, for example, but other applications are also known. For example, asymmetry can be measured by comparing opposite parts of the diffraction spectrum (for example, comparing the -1st and +1^{st} orders in the diffraction spectrum of a periodic grating). This can be done as described above and as described, for example, in U.S. patent application publication US 2006-066855, which is incorporated herein in its entirety by reference. Another application of diffraction-based metrology is in the measurement of feature width (CD) within a target.

Thus, in a device fabrication process (e.g., a patterning process, a lithography process, etc.), a substrate or other objects may be subjected to various types of measurement during or after the process. The measurement may determine whether a particular substrate is defective, may establish adjustments to the process and apparatuses used in the process (e.g., aligning two layers on the substrate or aligning the patterning device to the substrate), may measure the performance of the process and the apparatuses, or may be for other purposes. Examples of measurement include optical imaging (e.g., optical microscope), non-imaging optical measurement (e.g., measurement based on diffraction such as the ASML YieldStar metrology tool, the ASML SMASH metrology system), mechanical measurement (e.g., profiling using a stylus, atomic force microscopy (AFM)), and/or non-optical imaging (e.g., scanning electron microscopy (SEM)). The SMASH (SMart Alignment Sensor Hybrid) system, as described in U.S. Pat. No. 6,961,116, which is incorporated by reference herein in its entirety, employs a self-referencing interferometer that produces two overlapping and relatively rotated images of an alignment marker, detects intensities in a pupil plane where Fourier transforms of the images are caused to interfere, and extracts the positional information from the phase difference between diffraction orders of the two images which manifests as intensity variations in the interfered orders.

Metrology results may be provided directly or indirectly to the supervisory control system SCS. If an error is detected, an adjustment may be made to exposure of a subsequent substrate (especially if the inspection can be done soon and fast enough that one or more other substrates of the batch are still to be exposed) and/or to subsequent exposure of the exposed substrate. Also, an already exposed substrate may be stripped and reworked to improve yield, or discarded, thereby avoiding performing further processing on a substrate known to be faulty. In a case where only some target portions of a substrate are faulty, further exposures may be performed only on those target portions which meet specifications.

Within a metrology system, a metrology apparatus is used to determine one or more properties of the substrate, and in particular, how one or more properties of different substrates vary, or different layers of the same substrate vary from layer to layer. As noted above, the metrology apparatus may be integrated into the lithographic apparatus LA or the lithocell LC or may be a stand-alone device.

To enable the metrology, one or more targets can be provided on the substrate. In an embodiment, the target is specially designed and may comprise a periodic structure. In an embodiment, the target is a part of a device pattern, e.g., a periodic structure of the device pattern. In an embodiment, the device pattern is a periodic structure of a memory device (e.g., a Bipolar Transistor (BPT), a Bit Line Contact (BLC), etc. structure).

In an embodiment, the target on a substrate may comprise one or more 1-D periodic structures (e.g., gratings), which are printed such that after development, the periodic structural features are formed of solid resist lines. In an embodiment, the target may comprise one or more 2-D periodic structures (e.g., gratings), which are printed such that after development, the one or more periodic structures are formed of solid resist pillars or vias in the resist. The bars, pillars, or vias may alternatively be etched into the substrate (e.g., into one or more layers on the substrate).

In an embodiment, one of the parameters of interest of a patterning process is overlay. Overlay can be measured using dark field scatterometry in which the zeroth order of diffraction (corresponding to a specular reflection) is blocked, and only higher orders processed. Examples of dark field metrology can be found in PCT patent application publication nos. WO 2009/078708 and WO 2009/106279, which are hereby incorporated in their entirety by reference. Further developments of the technique have been described in U.S. patent application publications US2011-0027704, US2011-0043791 and US2012-0242970, which are hereby incorporated in their entirety by reference. Diffraction-based overlay using dark-field detection of the diffraction orders enables overlay measurements on smaller targets. These targets can be smaller than the illumination spot and may be surrounded by device product structures on a substrate. In an embodiment, multiple targets can be measured in one radiation capture.

As lithography nodes keep shrinking, more and more complicated wafer designs may be implemented. Various tools and/or techniques may be used by designers to ensure complex designs are accurately transferred to physical wafers. These tools and techniques may include mask optimization, source mask optimization (SMO), OPC, design for control, and/or other tools and/or techniques. For example, a source mask optimization process is described in United States Patent No. 9,588,438 titled "Optimization Flows of Source, Mask and Projection Optics", which is incorporated in its entirety by reference.

The present systems, and/or methods may be used as stand-alone tools and/or techniques, and/or or used in conjunction with semiconductor manufacturing processes, to enhance the accurate transfer of complex designs to physical wafers.

As described above, the present cleaning system is configured to be used to clean a clamp of a lithographic apparatus in-situ, while the lithographic apparatus continues to operate. For example, the cleaning system may simply replace a typical reticle inserted into the lithographic apparatus. The lithographic apparatus may move the cleaning system through typical movements and/or positions of the replaced reticle such that the lithographic apparatus does not require special adjustments for the cleaning system during operation. The cleaning system is configured to be inserted into, and automatically handled (e.g., moved, rotated, etc.) by, the lithographic apparatus just as any other mask or reticle is inserted into, and automatically handled by, the lithographic apparatus.

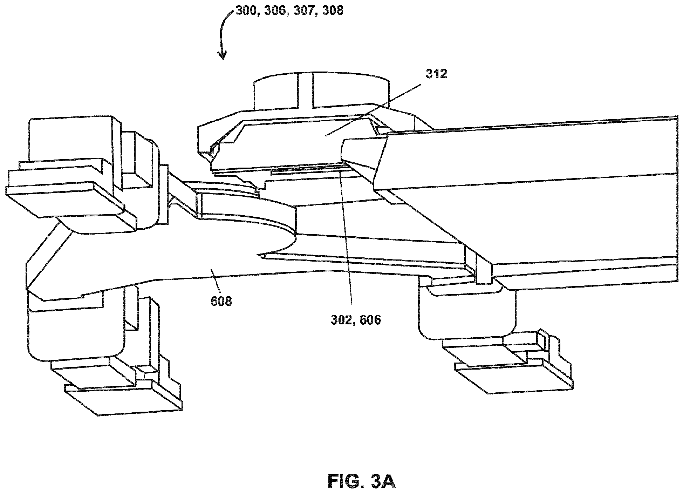

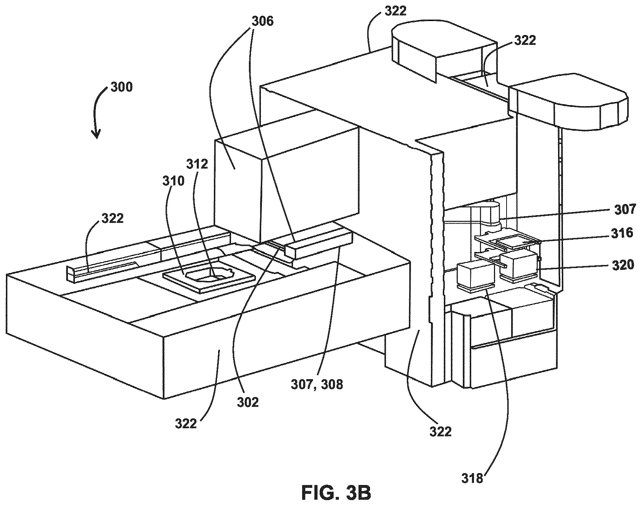

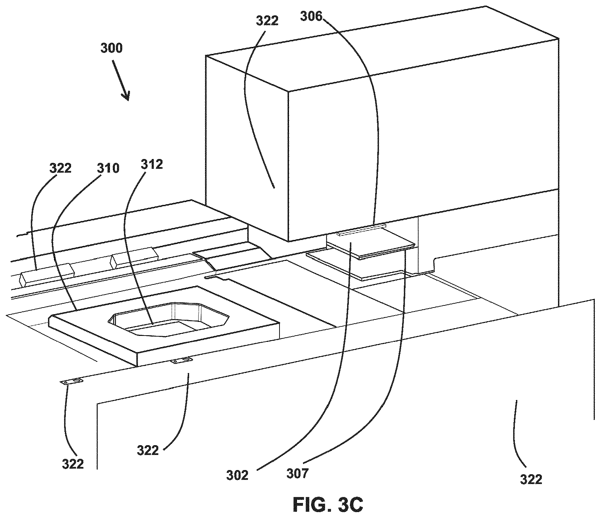

By way of a non-limiting example, Fig. 3A, Fig. 3B, and Fig. 3C illustrate example portions of lithographic apparatuses 300 (e.g., similar to an or the same as the lithographic apparatus shown in Fig. 1). Fig. 3A illustrates a portion of an extreme ultra violet (EUV) lithographic apparatus. Fig. 3B illustrates a portion of a deep ultra violet (DUV) lithographic apparatus. Fig. 3C is an enlarged view of a portion of the lithographic apparatus shown in Fig. 3B, according to an embodiment.

Fig. 3A illustrates an example embodiment of present cleaning system 302 (e.g., in transit to and/or in proximity to a clamp 312 of lithographic apparatus 300) and various components of lithographic apparatus 300 including a tool handler 306, 307, 308, and/or other components. In some embodiments, cleaning system 302 comprises a body, cleaning features disposed (e.g., patterned) on a clamp engaging and/or otherwise facing surface of the body, and/or other components. These components are described in turn, below.

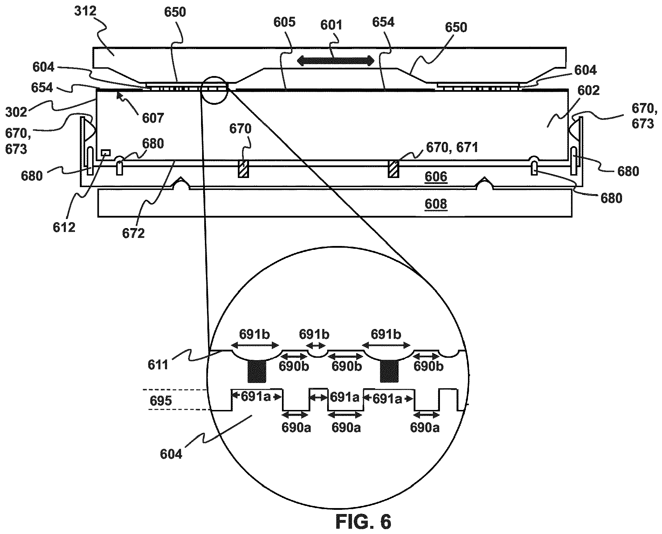

Lithographic apparatus 300 may include an EUV inner pod (EIP) 606 (which is shown an described in further detail related to Fig. 6 below), a rapid exchange device (RED) 608 (which is also shown and described in further detail related to Fig. 6 below), and/or other components. Regarding EIP 606 and Fig. 3A, cleaning system 302 (e.g., a cleaning reticle) is configured to be brought into system 300 using a reticle pod. Cleaning system 302 is secured from the outside environment in an inner pod. Cleaning system 302 in the inner pod is placed on an EUV inner pod (EIP 606) baseplate. Cleaning system 302 is moved from outside vacuum through the reticle handling system on to the turret of RED 608 (e.g., which may form a portion of elements 306, 307, and/or 308), which holds the EIP 606 baseplate in place while the reticle stage makes contact with cleaning system 302. RED 608 supports the EIP 606 baseplate and hence cleaning system 302, while small lateral (e.g., cleaning) movements are made. In this example, cleaning system 302 is held against gravity and the reticle handler (e.g., 306, 307, and/or 308) is below clamp 312.

In some embodiments, lithographic apparatus 300 can be configured for deep ultraviolet (DUV) lithography with one or more adjustments from what is shown in Fig. 3A. Fig. 3B illustrates an example DUV apparatus with an embodiment of present cleaning system 302 (e.g., in transit to and/or from a clamp 312 of lithographic apparatus 300 in these figures) and various components of lithographic apparatus 300 including a tool handler 306, 307, 308, reticle chuck 310, reticle clamp(s) 312, and/or other components.

In some embodiments, tool handler 306, 307, 308 comprises a reticle handler turret gripper 306, a reticle handler robot gripper 307 (having associated components 308, etc. for gripping a reticle during transport), and/or other components. Reticle handler robot gripper 307 may, for example, move a reticle from a pod 320 (e.g., after a user places a reticle in pod 320). Reticle handler turret gripper 306 may, for example, move a reticle from reticle handler robot gripper 307 to reticle clamp(s) 312. Lithographic apparatus 300 may include various other mechanical components 322 (translation mechanisms, elevation mechanisms, rotational mechanisms, motors, power generation and transmission components, structural components, etc.) configured to facilitate movement and control of cleaning system 302 through lithographic apparatus 300. For example, lithographic apparatus 300 may include an EUV inner pod (EIP), and a rapid exchange device (RED) (not shown in Fig. 3A, but further described below), and/or other components.

Cleaning system 302 is configured to be used to clean clamp(s) 312 (e.g., reticle clamp(s)) of lithographic apparatus 300 in-situ, while lithographic apparatus 300 continues to operate. Cleaning system 302 is configured to be inserted into, and automatically handled by, lithographic apparatus 300 just as any other mask or reticle 316 is automatically inserted into, and handled by, lithographic apparatus 300. For example, cleaning system 302 is sized and shaped to be inserted into lithographic apparatus 300 at a typical insertion point 318 using a typical insertion method, just as any other reticle 316 would be inserted into apparatus 300.

Fig. 3C is an enlarged view of a portion of apparatus 300. Fig. 3C shows cleaning system 302, reticle handler turret gripper 306, reticle stage 310, reticle stage reticle clamp(s) 312, mechanical components 322, reticle handler robot gripper 307, and/or other components. As shown in Fig. 3C, reticle handler turret gripper 306 is configured to move cleaning system 302 from reticle handler robot gripper 307 to reticle clamp(s) 312 so cleaning system 302 can be used to clean clamp(s) 312 in situ. Moving cleaning system 302 may comprise moving cleaning system toward or away from the clamp(s) 312 in horizontal, vertical, and/or other directions. Reticle handler turret gripper 306 and/or reticle handler robot gripper 307 may include various motors, translators, rotational components, clamps, clips, power sources, power transmission components, vacuum mechanisms, and/or other components that facilitate the movement of cleaning system 302.

Contamination particles on clamp reticle contact areas, such as burls, often aggregate and grow bigger over time on a clamp surface, hence the need for regular cleaning. Contamination particles typically range between about 2 - 5µm in a lateral dimension, and up to about 100 - 200nm in height (or thickness from the surface of a burl of the clamp). As the number of particles increases and the sizes of the contamination particles grow, performance degradation such as overlay drift and/or other problems may occur. The overlay can drift by as much as about 1nm within a relatively short period of time (e.g., 1-3 months), for example, and thus requires frequent cleaning, as this drift is intolerable for semiconductor production. Apparatuses, systems, and methods for cleaning relevant portions (e.g., clamp reticle contact areas) of a lithographic apparatus are therefore desirable.

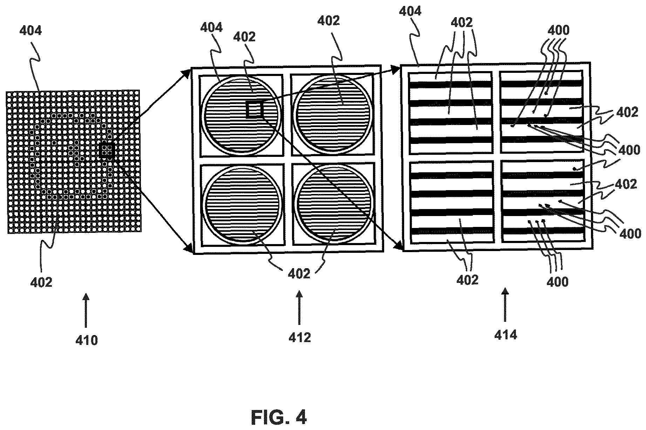

Fig. 4 illustrates examples of contamination particles 400 on reticle contact areas 402 of a reticle clamp 404. In this example, reticle contact areas 402 are burl surfaces. Burl surfaces may undulate and/or have other shapes so that only certain portions of a burl touch a reticle. View 410 of Fig. 4 illustrates white light interferometer data showing contaminated burls (in a circular distribution) on a clamp. The contamination may appear at burl surface peaks, for example, for an embodiment with an undulating surface. View 412 illustrates a relatively low magnification (e.g., 20X) image of four different burls. View 414 illustrates higher magnification (e.g., 100X) images showing clean burls on the left side and contaminated burls on the right side of view 414. Note that each burl has ridge surfaces, or tops, that form reticle contact areas 402.

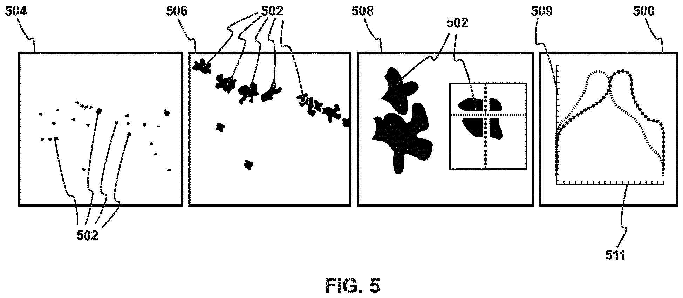

Fig. 5 illustrates dimensional information 500 about typical contamination particles 502. Fig. 5 shows a lower magnification scanning electron microscope (SEM) image 504 of contamination particles 502, a higher magnification SEM image 506 of contamination particles 502, atomic force microscopy (AFM) dimensional measurements 508 taken on contamination particles 502, and dimensional information 500 (showing an AFM cross section) obtained about a contamination particle 502. Measurements 508 include different profiles (profile 1 and profile 2) marked as shown on a contamination particle 502. Dimensional information 500 includes height 509 (e.g., from a burl surface) versus distance 511 (e.g., across a contamination particle 502) information for each profile from measurements 508.

In Fig. 5, typical locations, distribution, and dimensions of contamination particles are shown using both SEM and AFM data (e.g., see image 504, image 506, measurements 508, and information 500). From ex-situ experience, using a glass puck, a shearing force is capable of effectively removing these contamination particles 502. Based on this and/or other knowledge, cleaning system 302 (Fig. 3A) has been configured with cleaning features disposed (e.g., patterned) on a clamp engaging and/or otherwise facing surface of a body, in locations that approximate the locations of each burl, dimensions (e.g., length, width, height) of the contamination particles, and the distribution of these clouds of contamination particles. In some embodiments, a cleaning feature pattern pitch and line width are chosen such that they match closely with the size and the distribution of the contamination particles. In this way, sufficient support between the clamp facing surface of the reticle and burl surfaces is created, and only a small lateral movement is needed to effectively remove and/or otherwise dislodge the contamination particles from the burl surfaces.

Fig. 6 illustrates an example embodiment of cleaning system 302. Cleaning system 302 includes a body 602, cleaning features 604, and/or other components. Cleaning system 302 is illustrated with clamp 312, EUV inner pod (EIP) 606, and rapid exchange device (RED) 608 (shown in Fig. 3A and described above). In some embodiments, EIP 606 is placed in system 302. In some embodiments, the turret gripper 306 is a portion of the RED 608, reticle handler robot gripper 307, and/or other portions of tool handler 306, 307, 308 described above and shown in Fig. 3A - 3C. For example, cleaning system 302 may be moved via the reticle handler robot gripper 307 onto RED 608 to position body 602 to perform the cleaning action. Reticle handler turret gripper 306 may include slots into which this pod slides with a three point support, for example.

Body 602 is configured to be inserted into the lithography apparatus, engaged by the tool handler (e.g., with EIP 606 described above) of the lithography apparatus, and be positioned by the tool handler (which includes RED 608) for cleaning clamp 312 of the lithography apparatus. Body 602 may have a rectangular shape, a square shape (which is also a form of a rectangular shape), and/or any other shape that allows system 302 to function as described. In some embodiments, body 602 may have a thickness of up to about 0.25 inches, though this is not intended to be limiting. For example, body 602 may be thinner than 0.25 inches to reduce the potential for sag (described below), and/or for other reasons.

As described above, tool handler comprises a reticle handler and a turret gripper (see discussion related to Fig. 3A and 3B above). The reticle handler is configured to move body 602 from a load port of the lithography apparatus to the turret gripper, and the turret gripper is configured to grip and move body 602 along with EIP 606 and RED 608 to a position adjacent to clamp 312, and adjust the position of body 602 if needed. Body 602 is shaped similar to or the same as a reticle that is typically engaged and positioned by the tool handler. For simplicity and to facilitate the discussion, Fig. 6 illustrates a side view of body 602 as a block of material shaped as a rectangular prism, formed from an opaque material. This is not intended to be limiting. In some embodiments, one or more portions of body 602 may be formed from transparent or nearly transparent material such as ultra-low thermal-expansion quartz (SFS), a transparent material such as glass, an opaque material such as metal, a polymer, a ceramic, and/or other materials. Fabrication of body 602 can utilize any number of materials, provided the external dimension and mass conform to typical standards for fabricating reticles.

In some embodiments, body 602 comprises one or more identification features 612. The one or more identification features 612 comprise one or more of a label, a bar code, an alignment mark, and/or other identification features. Body 602 is configured such that identification features 612 are used (e.g., lithography apparatus 300 shown in Fig. 3A, 3B) so that body 602 can be properly identified, loaded into, and received by lithography apparatus 300, and positioned by lithography apparatus 300 for cleaning.

Cleaning features 604 are configured to clean contamination particles from clamp 312. Cleaning may include removal of the contamination particles, flattening of the contamination particles, and/or other cleaning such that the overlay performance is restored. Cleaning features 604 are disposed (e.g., patterned) on a clamp engaging and/or otherwise facing surface 605 of body 602. The locations, spacing, and dimensions of cleaning features 604 on clamp facing surface 605 approximate locations, spacing, and dimensions of the contamination particles on the clamp (described above), such that relative movement 601 between cleaning features 604 and clamp 312 cleans the contamination particles from clamp 312. In some embodiments, relative movement comprises lateral movement, serpentine movement, circular movement, or a combination thereof (e.g., such that movement in any direction is possible). In some embodiments, the relative movement ranges from about a few tenths of a micrometer (µm) to about 4 millimeters (mm). In some embodiments, the relative movement ranges from about a few tenths of a micrometer (µm) to about 4 millimeters (mm) in a non-scan direction of the lithography apparatus, and up to about 2mm in a scan direction of the lithography apparatus.

In some embodiments, cleaning features 604 are formed by a patterned coating 607 on a clamp engaging surface and/or otherwise clamp facing surface 605 of body 602. For example, patterned coating 607 may be formed by a chromium nickel (CrN) coating, and/or other coatings. In some embodiments, cleaning features 604 are etched into clamp facing surface 605. In some embodiments, cleaning features 604 are patterned on clamp facing surface 605 of body 602 using photolithography. This may include a series of repeating patterning operations. These may include, for example, masking, exposing, etching, and/or other operations typically utilized for photolithography.

The locations of cleaning features 604 on clamp facing surface 605 correspond to reticle contact areas 650 on clamp 312 where the contamination particles are located. The reticle contact areas can be formed by burls, or burl surfaces, for example, and/or other features. The spacing and/or dimensions of cleaning features 604 comprise a pitch 690a and a line width 691a that correspond to a pitch 690b and a line width 691b of reticle contact areas on the clamp where the contamination particles are located (e.g., burl surfaces 611); a thickness 695 that corresponds to a thickness of the contamination particles (contamination particles are not shown in Fig. 6), and/or other dimensions. In some embodiments, the pitch of a pattern of cleaning features 604 can vary from about 1 µm (approximate size of particles on the low end) to up to about 200µm (about half the diameter of a burl). The line widths can be a few 100's of nanometers to a few microns. Observed particles are often spaced at about > 2µm up to about 20µm from each other on the burl top touching the reticle.

In some embodiments, a thickness of the cleaning features is up to about 300nm. In some embodiments, a thickness of the cleaning features is up to about 250nm. In some embodiments, a thickness of the cleaning features is up to about 200nm. In some embodiments, a thickness of the cleaning features is up to about 150nm. Note that the circular inset drawing shown in Fig. 6 is an example shown for general understanding, and is not drawn to scale. Note that burl surfaces 611 and/or corresponding cleaning features 604 may be formed in a regular, repeating pattern, an irregular pattern, and/or some combination thereof (e.g., as shown in Fig. 6).

In some embodiments, clamp 312 is an electrostatic clamp. The electrostatic clamp is configured to clamp body 602 such that sag of body 602 is mitigated, but the relative movement between cleaning features 604 and the electrostatic clamp (e.g. clamp 312) is still permitted. Sag may be thought of as bowing or flexing shown by body 602 caused by gravity and/or other forces acting on body 602. For example, clamp 312 may be an electrostatic clamp which is configured to clamp the body using a voltage of about 200V-400V, which is enough voltage to mitigate sag, but not so much voltage that cleaning features 604 and clamp 312 cannot move relative to each other.

In some embodiments, cleaning system 302 includes one or more support structures 670 configured to support a second surface 672 and/or other surfaces of body 602 such that sag of body 602 is mitigated and/or for other reasons. Second surface 672 is opposite clamp facing surface 605 on body 602. In some embodiments, one or more support structures may be posited on one or more sides of body 602, and/or in other locations. Support structures 670 may include pins, posts, springs, edges, spacers, ridges, and/or other support structures. In this example, support structures 670 are formed by pins 671, and/or side supports 673.

In some embodiments, cleaning system 302 comprises one or more constraint structures 680 configured to constrain movement of body 602, such that movement 601 of clamp 312 relative to cleaning features 604 cleans the contamination particles from clamp 312. Constraint structures 680 may include pins, clips, clamps, screws, adhesive, hooks, and/or other constraint structures. In some embodiments, body 602 is constrained by containment pins (one possible example of constraint structures 680) of a baseplate of EIP 606.

By way of a non-limiting example, cleaning system 302 (Fig. 6) may be loaded, like any other reticle, inside a normal EIP and clamped to an electrostatic clamp with a relatively low voltage (e.g., about 200 - 400V, as described above). This voltage may be chosen such that any bowing or flexing caused by gravity sag is overcome, and such that some amount of extra force is provided to ensure the clamp burl surfaces are in contact with the cleaning features (e.g., 604 shown in Fig. 6) of body 602 (Fig. 6). Once cleaning system 302 is clamped in this way, a short stroke of the lithography apparatus (e.g., lithography apparatus 300 shown in Fig. 3A) may move slowly in a scan direction until a side of body 602 touches containment pins / constraint structures 680 (this moment in time can be detected by the Y-motor signals of the lithography apparatus). Once body 602 is constraint against the pins / constraint structures 680, a movement of about half the furrow pitch (~10µm), for example, of a burl may be used to dislodge and/or otherwise move contamination particles either onto the cleaning system 302 or into the furrows of a burl. This movement can also be longer than 10µm, it can be reversed in direction, and/or be moved in other directions (e.g., as described above). If it is not preferred to move the reticle against the pins, modifications to the EIP can be made to constrain the reticle in other ways, for example.

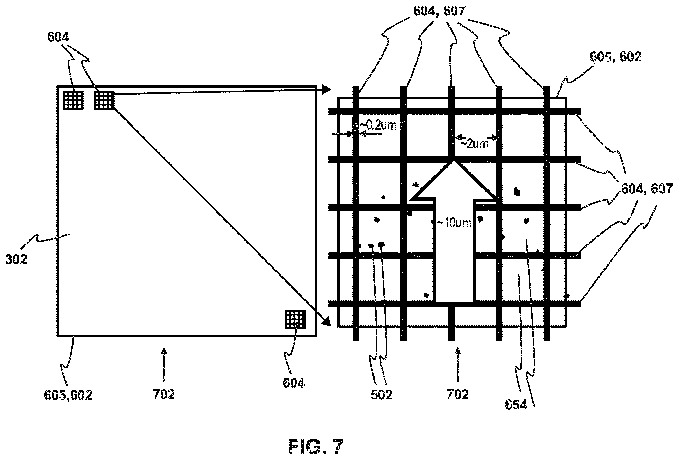

As shown in Fig. 6, the locations of cleaning features 604 alternate with gripping areas 654 on clamp facing surface 605. Fig. 7 illustrates how the locations of cleaning features 604 alternate with gripping areas 654 on clamp facing surface 605 in a macro pattern 702 across an entirety of clamp facing surface 605. This pattern may correspond to the thousands of burl surfaces that may be present on a given clamp surface, for example. This pattern may have many different possible shapes. The pattern may be formed based on the direction and/or magnitude of cleaning movements, for example, and/or other factors. Note that the present disclosure is not limited to making patterns only in burl contact areas. Patterns can be formed anywhere, such that perfect alignment between cleaning features and particles is not a concern. However, in some embodiments, the pattern extent can be limited to individual burl areas which will then result in 1000's of repeating patterns to match the burls.

In this example, a cartesian grid is etched into coating 607 on clamp facing surface 605 of body 602 that is relatively open (e.g., -75%), yet still is configured for sufficient support by burl surfaces, and has a relatively low chance of simply compressing contamination particles. In this example, cleaning features 604 are about 0.2µm wide, and gripping areas 654 are about 2µm wide. In this example, a cleaning movement of about 10 µm may be sufficient to dislodge contamination particles. In this example, by shifting cleaning system 302 in an XY plane by about +/- 500µm, at least nine clean/fresh areas on clamp facing surface 605 can be used to repeat cleaning operations across a clamp. Also, different patterns than the cartesian grid shown in Fig. 7 can be easily explored since cleaning features 604 can be formed with lithographically based techniques. It should be noted that the example dimensions shown in Fig. 7 are not intended to be limiting. These dimensions may have any values that allow cleaning system 302 to function as described.

A scanner is typically configured to load a reticle such that it could be offset in the X and Y direction by 0.5mm each. This provides the freedom for reticle contact at nine fresh locations. Each time an offset of X and/or Y is applied, the clamp then contacts a completely fresh location on the reticle (clamp facing surface). This improves the cleaning efficiency in this application as the contamination that is removed now does not get transferred back or cross contaminate another scanner when the same reticle is used elsewhere. It also helps extend the life of a given cleaning reticle (e.g., cleaning system 302). If one location is contaminated or damaged, a different location may be used simply by offsetting.

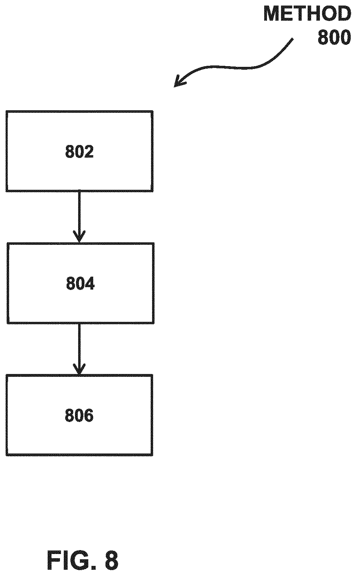

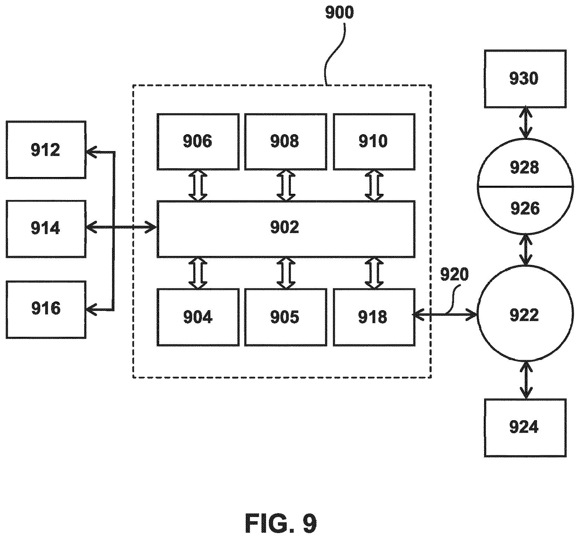

Fig. 8 illustrates a method 800 for cleaning a clamp of a lithography apparatus. Cleaning may include flattening and/or removal of contamination particles from the clamp, and/or other operations. Method 800 may be performed with a cleaning system, for example, as described herein. In some embodiments, the cleaning system comprises a body, cleaning features, and/or other components. In some embodiments, movement of the cleaning system and/or the lithography apparatus, patterning of the cleaning features, and/or other operations are controlled by one or more processors and/or a computing system, as described below (see Fig. 9). The operations of method 800 presented below are intended to be illustrative. In some embodiments, method 800 may be accomplished with one or more additional operations not described, and/or without one or more of the operations discussed. Additionally, the order in which the operations of method 800 are illustrated in Fig. 8 and described below is not intended to be limiting.

In some embodiments, one or more operations of method 800 may be implemented in and/or controlled by one or more processing devices (e.g., a digital processor, an analog processor, a digital circuit designed to process information, an analog circuit designed to process information, a state machine, and/or other mechanisms for electronically processing information, as described with respect to Fig. 9 below). The one or more processing devices may include one or more devices executing some or all of the operations of method 800 in response to instructions stored electronically on an electronic storage medium. The one or more processing devices may include one or more devices configured through hardware, firmware, and/or software to be specifically designed for execution of one or more of the operations of method 800 (e.g., see discussion related to Fig. 9 below). For example, the one or more processing devices may run software configured to control movement of the cleaning system by the lithography apparatus that causes one or more of the operations of method 800 to be performed.

At an operation 802, cleaning features are disposed (e.g., patterned) on a clamp engaging and/or otherwise facing surface of the body. The locations, spacing, and dimensions of the cleaning features on the clamp facing surface approximate the locations, spacing, and dimensions of the contamination particles on the clamp when the clamp facing surface is held by and/or positioned in proximity to the clamp. The locations of the cleaning features on the clamp facing surface correspond to reticle contact areas on the clamp where the contamination particles are located, for example. In some embodiments, the reticle contact areas comprise burls on the clamp. In some embodiments, the locations of the cleaning features alternate with gripping areas on the clamp facing surface in a macro pattern across an entirety of the clamp facing surface. The dimensions of the cleaning features comprise a pitch and a line width that correspond to a spacing and approximate locations of contamination particles on the surface of the clamp, a thickness that corresponds to a thickness of the contamination particles, and/or other dimensions. For example, a thickness of the cleaning features may be about 200nm.

In some embodiments, the cleaning features are formed by patterning a coating on the clamp facing surface of the body. In some embodiments, forming the cleaning features comprises etching the cleaning features into the clamp facing surface. For example, the cleaning features may be patterned on the clamp facing surface of the body using photolithography. In some embodiments, operation 802 is performed by a processor, a patterned layer and/or other portion of the cleaning system body (e.g., as described herein), and/or other components.

At an operation 804, the cleaning system is inserted into and received by the lithography apparatus. In some embodiments, the cleaning system comprises a reticle sized and shaped (e.g. having a rectangular and/or square cross section) body. The body is shaped similar to or the same as a reticle that is typically engaged and positioned by the tool handler. In some embodiments, the body comprises one or more identification features. In some embodiments, the one or more identification features comprise one or more of a label, a bar code, and an alignment mark. In some embodiments, operation 802 is performed by a tool handler of the lithography apparatus (e.g., reticle handler robot gripper 307 shown in Fig. 3A and 3B and described herein) and/or other components.

In some embodiments, operation 804 comprises engaging and moving the cleaning system with a second portion of the tool handler of the lithography apparatus to a position at or near a clamp of the lithography apparatus for cleaning. In some embodiments, the second portion of the tool handler may be a reticle handler turret gripper and/or other components. The turret gripper is configured to grip and move the body (and/or other components coupled to or otherwise associated with the body) to a position adjacent the clamp of the lithography apparatus, and adjust the position of the body (e.g., to position the body properly for gripping by the clamp).

The clamp may be an electrostatic clamp and/or other clamps, for example. The electrostatic clamp is configured to clamp the body such that sag of the body is mitigated, but relative movement between the cleaning features and the electrostatic clamp is still permitted. For example, the electrostatic clamp may be configured to clamp the body using a voltage of about 200V-400V. In some embodiments, the reticle handler turret gripper is the same as or similar to turret gripper 306 (shown in Fig. 3A and 3B and described herein).

At operation 806, relative movement between the cleaning features and the clamp is caused. The relative movement is configured to clean the contamination particles from the clamp. The relative movement comprises lateral movement, serpentine movement, circular movement, or a combination thereof. For example, the relative movement may range from about a few tenths of a micrometer (µm) to about 4 millimeters (mm). As another example, the relative movement may range from about a few tenths of a micrometer (µm) to about 4 millimeters (mm) in a non-scan direction of the lithography apparatus, and to about 2mm in a scan direction of the lithography apparatus.

In some embodiments, the cleaning system includes one or more support structures configured to support a second surface of the body opposite the clamp facing surface, such that sag of the body is mitigated. In some embodiments, the cleaning system includes one or more constraint structures configured to constrain movement of the body, such that movement of the clamp relative to the cleaning features cleans the contamination particles from the clamp.

In some embodiments, operation 806 comprises receiving entry and/or selection of control commands from a user via a user interface. The control commands comprise instructions for moving the body and the cleaning features based on a region on interest of the chuck of the lithography apparatus, and/or other control commands. In some embodiments, operation 1008 is performed by the one or more processors described herein (e.g., processors 904, 905, etc., shown in Fig. 9), a lithography apparatus, and/or other components.

The above-described techniques are implementations of a first embodiment. In the first embodiment, the cleaning process may comprise moving the cleaning system 302, at a relatively low speed in the scan direction, until it contacts containment pins / constraint structures 680.

According to a second embodiment, the cleaning process alternatively comprises moving the cleaning system 302 in an oscillatory movement with a relatively high frequency. The second embodiment may also differ from the first embodiment by the cleaning system 302 not being moved into contact with other structures, such as the containment pins / constraint structures 680. The cleaning process of the second embodiment may be similarly based on relative movement, or slip, occurring between the cleaning system 302 and the reticle clamp 312.

In the second embodiment, the cleaning system 302 may be substantially the same as described for the first embodiment. Accordingly, the cleaning system 302 may comprise a body 602, with cleaning features 604 arranged on a clamp facing surface 605 of the body 602.

In the second embodiment, the cleaning system 302 may be loaded onto the reticle clamp 312 so that the cleaning system 302 may clean the reticle clamp 312 in situ. The process of moving the cleaning system 302 to the reticle clamp 312, and loading the cleaning system 302 onto the reticle clamp 312, may be as described for the first embodiment. A difference to the first embodiment is that the reticle clamp 312 may initially hold the cleaning system 302 securely, so that substantially no relative movement between the reticle clamp 312 and the cleaning system 302 may occur.

The short stroke of the lithography apparatus may then move the reticle clamp 312, and thereby the cleaning system 302 that is secured to the reticle clamp 312, back and forth in an oscillatory movement. The cleaning system 302 may be moved in two opposite directions along the same linear path. The distance that the cleaning system 302 is moved may be in the range of about 20µm to about 2000µm, is preferably in the range of about 300µm to 500µm, and may be about 400µm. The maximum distance that the cleaning system 302 may be moved may be dependent on the specific designs of the cleaning system 302 and reticle clamp 312. In particular, the cleaning system 302 should not be moved so far that an end stop is accidentally hit. Such a collision may damage the cleaning system 302 and/or reticle clamp 312. The minimum distance that the cleaning system 302 may be moved may be dependent on the acceleration capabilities of the motors. If the distance is too small then the speed that the cleaning system has been accelerated to may not be sufficient for slip to occur. The frequency of the oscillatory movement may be in the range of about 5Hz to 500Hz, preferably in the range of about 100Hz to 300Hz, and may be about 200Hz. The cleaning process may be referred to as sonic cleaning. The direction that the cleaning system 302 is moved in by the oscillatory movement may parallel to the scan direction, or in any other direction.

Due to the initial secure clamping of the cleaning system 302, there may be no relative movement between the cleaning system 302 and the reticle clamp 312 when the oscillatory movement is performed before the cleaning process has been started. To start the cleaning process, the clamping force may be reduced so that relative movement between the cleaning system 302 and the reticle clamp 312 occurs. During a single period of the oscillatory movement, the cleaning system 302 may move by about 20µm to 25µm relative to the reticle clamp 312.

To end the cleaning process, the oscillatory movement may be slowed down and stopped. The cleaning system 302 may then be unloaded from the reticle clamp 312.

The reticle clamp 312 may be an electro-static clamp. The initial clamping voltage may be about 900V so that the cleaning system 302 is securely held to the reticle clamp 312. There may therefore be no relative movement between the reticle clamp 312 and the cleaning system 302 when the oscillatory movement performed and the initial clamping voltage applied. To start the cleaning process, the clamping force may then be reduced by reducing the clamping voltage from the initial clamping voltage. The clamping voltage may be reduced so that the weaker clamping force allows the oscillatory movement to cause relative movement between the cleaning system 302 and the reticle clamp 312. The clamping voltage may be reduced to, for example, about 750V.

In a preferred implementation of the second embodiment, the voltage that the clamping voltage is reduced to for the cleaning process is determined in dependence on servo feedback. The short stroke may operate with one or more servos that are used for controlling the movement of the reticle clamp 312. A servo current, which is the current in one or more of the servos, may be measured and used to determine if the cleaning system 302 is securely held to the reticle clamp 312, or if the cleaning system 302 is able to move relative to the reticle clamp 312. When the cleaning system 302 is securely held to the reticle clamp 312, the moved mass includes the entire mass of the cleaning system 302. When the cleaning system 302 moves relative to the reticle clamp 312, the moved mass is reduced. The servo current is dependent on the moved mass. In particular, the moved mass is translated into a servo current, with the magnitude of the servo current being dependent on the moved mass. A change in the servo current may therefore be used to determine that the cleaning system 302 has changed from being securely held to the reticle clamp 312 to moving relative to the reticle clamp 312.

The process of allowing relative movement between the cleaning system 302 and reticle clamp 312 may comprise measuring the servo current when the oscillatory movement is performed and the initial clamping voltage is applied. With the initial clamping voltage applied, the cleaning system 302 is securely held to the reticle clamp 312 and unable to move relative to the reticle clamp 312. The clamping voltage may then be decreased, and the servo current monitored, with the oscillatory movement performed. The clamping voltage may be decreased until a change in the servo current is detected. Preferably, the clamping voltage is reduced slowly so that the change in the servo current is detected before a substantial further reduction in the clamping voltage is made. The change in the servo current is an indication that the cleaning system 302 is moving relative to the reticle clamp 312. The clamping voltage may be reduced until a predetermined change of the servo current has occurred. The predetermined change of the servo current may be, of example, in the range 0.1% to 10%, such as 2%. For example, the initial clamping voltage may be in the range of about 800V to 1000V, such as about 900V. The clamping voltage may be reduced to a voltage in the range of about 500V to 800V, such as about 750V. The applied clamping force is dependent on the clamping voltage and so lowering the clamping voltage may allow the cleaning system 302 to move relative to the reticle clamp 312.

The specific required clamping force for allowing appropriate relative movement between the cleaning system 302 and the reticle clamp 312 may depend on properties and circumstances that may result in the required clamping force varying between operations of the cleaning process. In particular, the specific required clamping force may depend on at least one or more of the specific properties of the cleaning system 302, the specific properties of the reticle clamp 312 and the characteristics of the applied oscillatory movement. By determining the applied clamping force in dependence on the servo current, the clamping force is determined in dependence on feedback. Advantageously, this allows the clamping force to be appropriately set given the different properties and circumstances that the clamping force depends on. The relative movement between the cleaning system 302 and the reticle clamp 312 may thereby be more accurately controlled than if a pre-determined reduction in clamping force was used.

Preferably, the locations that the cleaning system 302 moves between are monitored throughout the cleaning process. The location of the cleaning system 302 may be determined using one or more transmission image sensors (TISs). The cleaning system 302 may comprises cleaning features on the side that faces the reticle clamp 312, and TISs on the side that faces away from the reticle clamp 312. The TISs may be used to determine and monitor the location of the cleaning system 302 during the oscillatory movement. Advantageously, an asymmetric slip of the cleaning system 302 may be detected. An asymmetric slip results in the cleaning system 302 not moving back and forth over the same intended locations. When an asymmetric slip is detected, the cleaning process may be stopped, or changed, so that the asymmetric slip does not substantially reduce the effectiveness of the cleaning process or result in damage occurring.

An advantage of the second embodiment over the first embodiment is that the control of the movement of the cleaning system 302 is improved. The clamping force may accurately set at an appropriate level for allowing a desired amount of relative movement between the cleaning system 302 and the reticle clamp 312.

All of the processes of the second embodiment may be controlled by a control system. The control system may be the computer system 900 described later with reference to Fig. 9.

The second embodiment includes a method for in-situ cleaning of a clamp of a lithography apparatus. A first step of the method comprises inserting a body into the lithography apparatus, the body comprising cleaning features disposed on a clamp engaging surface of the body. A second step of the method comprises using a first clamping force to engage the body with the clamp. A third step of the method comprises performing an oscillatory movement of the clamp with the first clamping force applied, wherein the first clamping force substantially prevents relative movement between the cleaning features and the clamp. A fifth step of the method comprises changing the clamping force from the first clamping force to a second clamping force, wherein the second clamping force is weaker than the first clamping force, so that relative movement between the cleaning features and the clamp occurs in response to the oscillatory movement.

Embodiments include a number of modifications and variations to the above described techniques.

In first embodiment, TISs may also be used to determine and monitor the location of the cleaning system 302 during the cleaning process. If an unintended movement of the cleaning system 302 is detected, the cleaning process may be stopped or changed.

In both the first and second embodiments, other type of sensor than TISs may be used to determine and monitor the location of the cleaning system 302 during the cleaning process.

In the first and second embodiments, the reticle clamp 312 may be a single clamp or comprise a plurality of clamps.

In the second embodiment, the oscillatory movement is not restricted to being a bi-directional movement along a linear path. The oscillatory movement may alternatively, or additionally, comprise one or more of a lateral movement, a serpentine movement and a circular movement.

In the second embodiment, a number of different pre-determined movement profiles for the oscillatory movement may be used. For example, different movement profiles may be stored in the computer system that controls the movement of the reticle clamp 312. The cleaning process may be performed in a number of different ways which are suited to cleaning different types of contamination. A specific one of the movement profiles may be selected and used in dependence on the desired way of performing the cleaning process given the contamination.

In the second embodiment, embodiments include alternative arrangements for determining and monitoring the location of the cleaning system 302 during the oscillatory movement. For example, there may be a pattern on the cleaning system 302 that is imaged through the lens onto a sensor on the substrate support WT. Alternatively, the substrate support WT could move in order to determine the amplitude of the cleaning system 302 movement.

In embodiments, the suggested clamping voltages are exemplary and embodiments include the use of different voltages from the specific stated clamping voltages, and ranges of clamping voltages. The actual used clamping voltages may depend on at least the specific design of the reticle clamp 312. For example, for different types and implementations of reticle clamp 312, the clamping voltage used during an exposure process may range from about 1kV (or less) to about 10kV (or more). The clamping voltage used during a cleaning process may be about half the clamping voltage used in the exposure process.

Fig. 9 is a block diagram that illustrates a computer system 900 that can assist in implementing the methods, flows, or the system(s) disclosed herein. Computer system 900 may be included in and/or electronically coupled to lithography apparatus LA described above (Fig. 1, Fig. 3A, etc.). Computer system 900 includes a bus 902 or other communication mechanism for communicating information, and a processor 904 (or multiple processors 904, 905, etc.) coupled with bus 902 for processing information. Computer system 900 also includes a main memory 906, such as a random access memory (RAM) or other dynamic storage device, coupled to bus 902 for storing information and instructions to be executed by processor 904. Main memory 906 also may be used for storing temporary variables or other intermediate information during execution of instructions to be executed by processor 904. Computer system 900 further includes a read only memory (ROM) 908 or other static storage device coupled to bus 902 for storing static information and instructions for processor 904. A storage device 910, such as a magnetic disk or optical disk, is provided and coupled to bus 902 for storing information and instructions.

Computer system 900 may be coupled via bus 902 to a display 912, such as a cathode ray tube (CRT) or flat panel or touch panel display for displaying information to a computer user. An input device 914, including alphanumeric and other keys, is coupled to bus 902 for communicating information and command selections to processor 904. Another type of user input device is cursor control 916, such as a mouse, a trackball, or cursor direction keys for communicating direction information and command selections to processor 904 and for controlling cursor movement on display 912. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more flows and/or methods described herein may be performed by computer system 900 in response to processor 904 executing one or more sequences of one or more instructions contained in main memory 906. Such instructions may be read into main memory 906 from another computer-readable medium, such as storage device 910. Execution of the sequences of instructions contained in main memory 906 causes processor 904 to perform the flows and/or process steps described herein. One or more processors in a multi-processing arrangement may also be employed to execute the sequences of instructions contained in main memory 906. In an alternative embodiment, hard-wired circuitry may be used in place of or in combination with software instructions. Thus, the description herein is not limited to any specific combination of hardware circuitry and software.

The term "computer-readable medium" or "machine readable medium" as used herein refers to any medium that participates in providing instructions to processor 904 for execution. Such a medium may take many forms, including but not limited to, non-volatile media, volatile media, and transmission media. Non-volatile media include, for example, optical or magnetic disks, such as storage device 910. Volatile media include dynamic memory, such as main memory 906. Transmission media include coaxial cables, copper wire and fiber optics, including the wires that comprise bus 902. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 904 for execution. For example, the instructions may initially be borne on a magnetic disk of a remote computer. The remote computer can load the instructions into its dynamic memory and send the instructions over a telephone line using a modem. A modem local to computer system 900 can receive the data on the telephone line and use an infrared transmitter to convert the data to an infrared signal. An infrared detector coupled to bus 902 can receive the data carried in the infrared signal and place the data on bus 902. Bus 902 carries the data to main memory 906, from which processor 904 retrieves and executes the instructions. The instructions received by main memory 906 may optionally be stored on storage device 910 either before or after execution by processor 904.

Computer system 900 may also include a communication interface 918 coupled to bus 902. Communication interface 918 provides a two-way data communication coupling to a network link 920 that is connected to a local network 922. For example, communication interface 918 may be an integrated services digital network (ISDN) card or a modem to provide a data communication connection to a corresponding type of telephone line. As another example, communication interface 918 may be a local area network (LAN) card to provide a data communication connection to a compatible LAN. Wireless links may also be implemented. In any such implementation, communication interface 918 sends and receives electrical, electromagnetic, or optical signals that carry digital data streams representing various types of information.

Network link 920 typically provides data communication through one or more networks to other data devices. For example, network link 920 may provide a connection through local network 922 to a host computer 924 or to data equipment operated by an Internet Service Provider (ISP) 926. ISP 926 in turn provides data communication services through the worldwide packet data communication network, now commonly referred to as the "Internet" 928. Local network 922 and Internet 928 both use electrical, electromagnetic, or optical signals that carry digital data streams. The signals through the various networks and the signals on network link 920 and through communication interface 918, which carry the digital data to and from computer system 900, are exemplary forms of carrier waves transporting the information.

Computer system 900 can send messages and receive data, including program code, through the network(s), network link 920, and communication interface 918. In the Internet example, a server 930 might transmit a requested code for an application program through Internet 928, ISP 926, local network 922 and communication interface 918. One such downloaded application may provide all or part of a method described herein, for example. The received code may be executed by processor 904 as it is received, and/or stored in storage device 910, or other non-volatile storage for later execution. In this manner, computer system 900 may obtain application code in the form of a carrier wave.

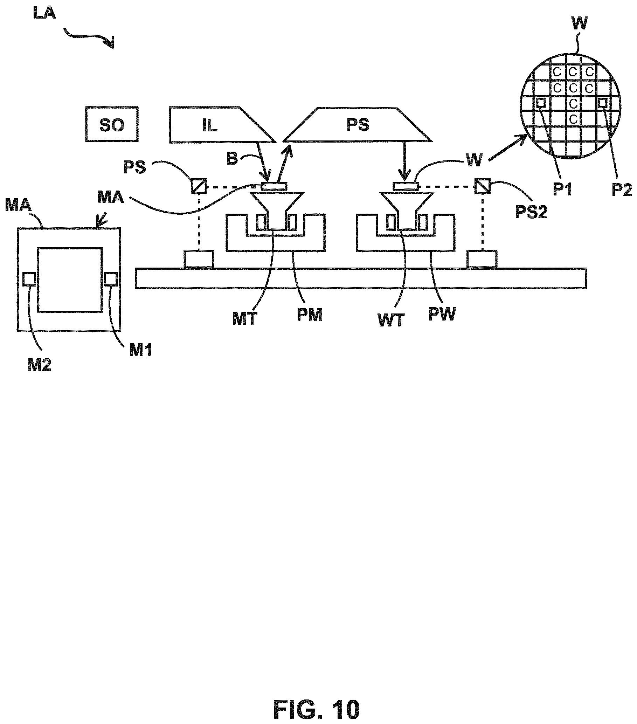

Fig. 10 schematically depicts an exemplary lithographic projection apparatus LA similar to and/or the same as the apparatus shown in Fig. 1, Fig. 3A, and/or Fig. 3B that can be used in conjunction with the techniques described herein. The apparatus comprises an illumination system IL configured to condition a beam B of radiation. In this example, the illumination system also comprises a radiation source SO. The apparatus comprises a first object table (e.g., patterning device table) MT provided with a patterning device holder to hold a patterning device MA (e.g., a reticle). It is connected to a first positioner to accurately position the patterning device with respect to item PS. The apparatus comprises a second object table (substrate table) WT provided with a substrate holder to hold a substrate W (e.g., a resist-coated silicon wafer). It is connected to a second positioner to accurately position the substrate with respect to item PS. The apparatus comprises a projection system ("lens") PS (e.g., a refractive, catoptric or catadioptric optical system) to image an irradiated portion of the patterning device MA onto a target portion C (e.g., comprising one or more dies) of the substrate W.

As depicted, apparatus LA is of a transmissive type (i.e., has a transmissive patterning device). However, in general, it may also be of a reflective type, for example (with a reflective patterning device). The apparatus may employ a different kind of patterning device to classic mask; examples include a programmable mirror array or LCD matrix.

The source SO (e.g., a mercury lamp or excimer laser, LPP (laser produced plasma) EUV source) produces a beam of radiation. This beam is fed into an illumination system (illuminator) IL, either directly or after having traversed conditioning means, such as a beam expander, for example. The illuminator IL may comprise adjusting means for setting the outer and/or inner radial extent (commonly referred to as σ-outer and σ-inner, respectively) of the intensity distribution in the beam. In addition, it will generally comprise various other components, such as an integrator and a condenser. In this way, the beam B impinging on the patterning device MA has a desired uniformity and intensity distribution in its cross-section.

It should be noted with regard to Fig. 10 that the source SO may be within the housing of the lithographic projection apparatus (as is often the case when the source SO is a mercury lamp, for example), but that it may also be remote from the lithographic projection apparatus, the radiation beam that it produces being led into the apparatus (e.g., with the aid of suitable directing mirrors); this latter scenario is often the case when the source SO is an excimer laser (e.g., based on KrF, ArF or F₂ lasing).

The beam B subsequently intercepts the patterning device MA, which is held on a patterning device table MT. Having traversed the patterning device MA, the beam B passes through the lens PL, which focuses the beam B onto a target portion C of the substrate W. With the aid of the second positioning means (and interferometric measuring means), the substrate table WT can be moved accurately, e.g. to position different target portions C in the path of the beam. Similarly, the first positioning means can be used to accurately position the patterning device MA with respect to the path of the beam B, e.g., after mechanical retrieval of the patterning device MA from a patterning device library, or during a scan. In general, movement of the object tables MT, WT is realized with the aid of a long-stroke module (coarse positioning) and a short-stroke module (fine positioning), which are not explicitly depicted. However, in the case of a stepper (as opposed to a step-and-scan tool) the patterning device table MT may just be connected to a short stroke actuator, or may be fixed.

As described above, LA can be used in two different modes. In step mode, the patterning device table MT is kept essentially stationary, and an entire patterning device image is projected in one operation (i.e., a single "flash") onto a target portion C. The substrate table WT is then shifted in the x and/or y directions so that a different target portion C can be irradiated by the beam. In scan mode, essentially the same scenario applies, except that a given target portion C is not exposed in a single "flash". Instead, the patterning device table MT is movable in a given direction (the so-called "scan direction", e.g., the y direction) with a speed v, so that the projection beam B is caused to scan over a patterning device image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

Various embodiments of the present systems and methods are disclosed in the subsequent first list of numbered clauses:
1. A system for cleaning contamination particles from a clamp of a lithography apparatus, the system comprising: a body configured to be inserted into the lithography apparatus, engaged by a tool handler of the lithography apparatus, and positioned by the tool handler for clamping by the clamp; and cleaning features patterned on a clamp facing surface of the body, wherein locations and dimensions of the cleaning features on the clamp facing surface approximate locations and dimensions of contamination particles typically found on reticle contact areas of the clamp, such that relative movement between the cleaning features and the clamp cleans the contamination particles from the clamp.
2. The system of clause 1, wherein the cleaning features are formed by a patterned coating on the clamp facing surface of the body.
3. The system of any of the previous clauses, wherein the cleaning features are etched into the clamp facing surface.
4. The system of any of the previous clauses, wherein the locations of the cleaning features on the clamp facing surface correspond to the reticle contact areas on the clamp where the contamination particles are typically located.
5. The system of any of the previous clauses, wherein the reticle contact areas comprise burls.
6. The system of any of the previous clauses, wherein the locations of the cleaning features alternate with gripping areas on the clamp facing surface in a macro pattern across an entirety of the clamp facing surface.
7. The system of any of the previous clauses, wherein the relative movement comprises lateral movement, serpentine movement, circular movement, or a combination thereof.
8. The system of any of the previous clauses, wherein the clamp is an electrostatic clamp.
9. The system of any of the previous clauses, wherein the electrostatic clamp is configured to clamp the body such that sag of the body is mitigated, but the relative movement between the cleaning features and the electrostatic clamp is still permitted.
10. The system of any of the previous clauses, further comprising one or more support structures configured to support a second surface of the body such that sag of the body is mitigated, the second surface opposite the clamp facing surface.
11. The system of any of the previous clauses, further comprising one or more constraint structures configured to constrain movement of the body, such that movement of the clamp relative to the cleaning features cleans the contamination particles from the clamp.
12. The system of any of the previous clauses, wherein the dimensions of the cleaning features comprise (1) a pitch and a line width that correspond to a pitch and a line width of reticle contact areas on the clamp where the contamination particles are located; and (2) a thickness that corresponds to a thickness of the contamination particles.
13. The system of any of the previous clauses, wherein the cleaning comprises flattening and/or removal of the contamination particles.
14. The system of any of the previous clauses, wherein the body has a rectangular shape, wherein the tool handler comprises a reticle handler and a turret gripper, wherein the reticle handler is configured to move the body from a load port of the lithography apparatus, and wherein the turret gripper is configured to position the body and any surrounding support structures for cleaning.
15. The system of any of the previous clauses, wherein the body comprises one or more identification features including one or both of a bar code and an alignment mark.
16. The system of any of the previous clauses, wherein a thickness of the cleaning features is about 200nm.
17. The system of any of the previous clauses, wherein the clamp is an electrostatic clamp which is configured to clamp the body using a voltage of about 200V-400V.
18. The system of any of the previous clauses, wherein the relative movement ranges from about a few tenths of a micrometer (µm) to about 4 millimeters (mm).
19. The system of any of the previous clauses, wherein the relative movement ranges from about a few tenths of a micrometer (µm) to about 4 millimeters (mm) in a non-scan direction of the lithography apparatus, and to about 2mm in a scan direction of the lithography apparatus.
20. The system of any of the previous clauses, wherein the cleaning features are patterned on the clamp facing surface of the body using photolithography.
21. A method for cleaning contamination particles from a clamp of a lithography apparatus, the method comprising: inserting a body into the lithography apparatus, the body comprising cleaning features disposed on a clamp engaging surface of a body, wherein locations and spacing of the cleaning features on the clamp engaging surface approximate locations and spacing of contamination particles on the clamp; engaging the body with the clamp; and causing relative movement between the cleaning features and the clamp to clean the contamination particles from the clamp.
22. The method of clause 21, wherein the cleaning features are formed by patterning a coating on the clamp engaging surface of the body.
23. The method of any of the previous clauses, wherein forming the cleaning features comprises etching the cleaning features into the clamp engaging surface.
24. The method of any of the previous clauses, wherein the locations of the cleaning features on the clamp engaging surface correspond to reticle contact areas on the clamp where the contamination particles are located.
25. The method of any of the previous clauses, wherein the reticle contact areas comprise burls, each burl having an undulating surface with peaks and valleys, and wherein the locations of the cleaning features on the clamp engaging surface correspond to peaks of burls on the clamp where the contamination particles are located.
26. The method of any of the previous clauses, wherein the locations of the cleaning features alternate with gripping areas on the clamp engaging surface in a macro pattern across an entirety of the clamp engaging surface.
27. The method of any of the previous clauses, wherein the relative movement comprises lateral movement, serpentine movement, circular movement, or a combination thereof.
28. The method of any of the previous clauses, wherein the clamp is an electrostatic clamp.
29. The method of any of the previous clauses, wherein the electrostatic clamp is configured to clamp the body such that sag of the body is mitigated, but the relative movement between the cleaning features and the electrostatic clamp is still permitted.
30. The method of any of the previous clauses, further comprising providing one or more support structures configured to support a second surface of the body such that sag of the body is mitigated, the second surface opposite the clamp engaging surface.
31. The method of any of the previous clauses, further comprising providing one or more constraint structures configured to constrain movement of the body, such that movement of the clamp relative to the cleaning features cleans the contamination particles from the clamp.
32. The method of any of the previous clauses, wherein dimensions of the cleaning features comprise (1) a pitch and a line width that correspond to a pitch and a line width of reticle contact areas on the clamp where the contamination particles are located; and (2) a thickness that corresponds to a thickness of the contamination particles.
33. The method of any of the previous clauses, wherein the cleaning comprises flattening and/or removal of the contamination particles.
34. The method of any of the previous clauses, wherein the body has a rectangular shape, wherein the engaging comprises engaging the body with a tool handler of the lithography apparatus, wherein the tool handler comprises a reticle handler and a turret gripper, wherein the reticle handler is configured to move the body from a load port of the lithography apparatus, and wherein the turret gripper is configured to position the body and any surrounding support structures for cleaning.
35. The method of any of the previous clauses, wherein the body comprises one or more identification features including one or both of a bar code and an alignment mark.
36. The method of any of the previous clauses, wherein a thickness of the cleaning features is about 200nm.
37. The method of any of the previous clauses, wherein the clamp is an electrostatic clamp which is configured to clamp the body using a voltage of about 200V-400V.
38. The method of any of the previous clauses, wherein the relative movement ranges from about a few tenths of a micrometer (µm) to about 4 millimeters (mm).
39. The method of any of the previous clauses, wherein the relative movement ranges from about a few tenths of a micrometer (µm) to about 4 millimeters (mm) in a non-scan direction of the lithography apparatus, and to about 2mm in a scan direction of the lithography apparatus.
40. The method of any of the previous clauses, wherein the cleaning features are patterned on the clamp engaging surface of the body using photolithography.
41. A system for cleaning contamination particles from a clamp of a lithography apparatus, the system comprising: a body configured to be inserted into the lithography apparatus, engaged by a tool handler of the lithography apparatus, and positioned by the tool handler for clamping by the clamp; and cleaning features patterned on a clamp facing surface of the body, wherein locations of the cleaning features on the clamp facing surface approximate locations of reticle contact areas on the clamp, such that relative movement between the cleaning features and the clamp cleans the contamination particles from the clamp.
42. The system of any of the previous clauses, wherein the cleaning features are formed by a patterned coating on the clamp facing surface of the body.
43. The system of any of the previous clauses, wherein the cleaning features are etched into the clamp facing surface.
44. The system of any of the previous clauses, wherein the reticle contact areas on the clamp comprise burls, each burl having an undulating surface with peaks and valleys, and wherein the locations of the cleaning features on the clamp facing surface correspond to peaks of burls on the clamp where the contamination particles are located.
45. The system of any of the previous clauses, wherein a size of the cleaning features corresponds to a size of the burl peaks.
46. The system of any of the previous clauses, wherein the locations of the cleaning features alternate with gripping areas on the clamp facing surface in a macro pattern across an entirety of the clamp facing surface.
47. The system of any of the previous clauses, wherein the relative movement comprises lateral movement, serpentine movement, circular movement, or a combination thereof.
48. The system of any of the previous clauses, wherein the clamp is an electrostatic clamp.
49. The system of any of the previous clauses, wherein the electrostatic clamp is configured to clamp the body such that sag of the body is mitigated, but the relative movement between the cleaning features and the electrostatic clamp is still permitted.
50. The system of any of any of the previous clauses, further comprising one or more support structures configured to support a second surface of the body such that sag of the body is mitigated, the second surface opposite the clamp facing surface.
51. The system of any of the previous clauses, further comprising one or more constraint structures configured to constrain movement of the body, such that movement of the clamp relative to the cleaning features cleans the contamination particles from the clamp.
52. The system of any of the previous clauses, wherein dimensions of the cleaning features comprise (1) a pitch and a line width that correspond to a pitch and a line width of reticle contact areas on the clamp where the contamination particles are located; and (2) a thickness that corresponds to a thickness of the contamination particles.
53. The system of any of the previous clauses, wherein the cleaning comprises flattening and/or removal of the contamination particles.
54. The system of any of any of the previous clauses, wherein the body has a rectangular shape, wherein the tool handler comprises a reticle handler and a turret gripper, wherein the reticle handler is configured to move the body from a load port of the lithography apparatus, and wherein the turret gripper is configured to position the body and any surrounding support structures for cleaning.
55. The system of any of the previous clauses, wherein the body comprises one or more identification features including one or both of a bar code and an alignment mark.
56. The system of any of the previous clauses, wherein a thickness of the cleaning features is about 200nm.
57. The system of any of the previous clauses, wherein the clamp is an electrostatic clamp which is configured to clamp the body using a voltage of about 200V-400V.
58. The system of any of the previous clauses, wherein the relative movement ranges from about a few tenths of a micrometer (µm) to about 4 millimeters (mm).
59. The system of any of the previous clauses, wherein the relative movement ranges from about a few tenths of a micrometer (µm) to about 4 millimeters (mm) in a non-scan direction of the lithography apparatus, and to about 2mm in a scan direction of the lithography apparatus.
60. The system of any of the previous clauses, wherein the cleaning features are patterned on the clamp facing surface of the body using photolithography.

Various embodiments of the present systems and methods are also disclosed in the subsequent second list of numbered clauses:
1. A system for in-situ cleaning of a clamp of a lithography apparatus, the system comprising:
   a body configured to be inserted into the lithography apparatus and engaged with a clamp,
   wherein cleaning features are arranged on a clamp facing surface of the body;
   a movement system of the clamp; and
   a control system;
   wherein the control system is configured to:
      control the clamp to use a first clamping force to engage the body with the clamp;
      control the movement system to move the clamp in an oscillatory movement with the first clamping force applied, wherein the first clamping force substantially prevents relative movement between the cleaning features and the clamp; and
      control the clamp to change the clamping force from the first clamping force to a second clamping force, wherein the second clamping force is weaker than the first clamping force, so that relative movement between the cleaning features and the clamp occurs in response to the oscillatory movement.
2. The system according to clause 1, wherein the oscillatory movement comprises bi-directional movements along a linear path.
3. The system according to clause 2, wherein a movement along the linear path is in a scan direction.
4. The system according to any preceding clause, wherein:
   the clamp is an electrostatic clamp;
   the clamp is configured to generate the first clamping force by applying a first clamping voltage; and
   the clamp is configured to generate the second clamping force by applying a second clamping voltage.
5. The system according to clause 4, wherein the first clamping voltage is in the range of about 800V to 1000V.
6. The system according to clause 4 or 5, wherein the second clamping voltage is in the range of about 500V to 800V.
7. The system according to any preceding clause, wherein the relative movement is over distances in a range from about 20µm to about 2000µm, is preferably in the range of about 300µm to 500µm, and may be about 400µm.
8. The system according to any preceding clause, wherein the oscillatory movement comprises a movement frequency in the range of about 5Hz to 500Hz, preferably in the range of about 100Hz to 300Hz, and more preferably about 200Hz.
9. The system according to any preceding clause, wherein the movement system further comprises one or more servos; and
   the control system is configured to:
   monitor a servo current, wherein the servo current is dependent on the current(s) in the one or
   more servos; and
   determine the second clamping force in dependence on the servo current.
10. The system according to clause 9, when dependent on clause 4, wherein changing the clamping force from the first clamping force to the second clamping force comprises the control system:
   determining the servo current when the first clamping voltage is applied and the oscillatory movement is performed;
   monitoring the servo current when the oscillatory movement is performed and the clamping voltage is reduced from the first clamping voltage; and
   determining the second clamping voltage when a predetermined change in the servo current has occurred.
11. The system according to any preceding clause, further comprising one or more sensors arranged to determine the location of the body;
   wherein the control system is configured to:
   monitor the location of the body using determined locations by the one or more sensors; and
   determine if an unintended movement of body has occurred in dependence of the monitoring.
12. The system according to clause 11, wherein the one or more sensors are transmission image sensors.
13. The system according to any preceding clause, wherein:
   the clamp comprises reticle contact areas;
   the reticle contact areas comprise end surfaces of burls; and
   the locations of the cleaning features on the clamp facing surface correspond to the end surfaces of the burls.
14. The system according to any preceding clause, wherein the control system is configured to:
   select one of a plurality of pre-determined movement profiles of the clamp; and
   control the movement system in dependence on the selected movement profile.
15. A lithographic apparatus comprising the system according to any preceding clause.
16. A method for in-situ cleaning of a clamp of a lithography apparatus, the method comprising:
   inserting a body into the lithography apparatus, the body comprising cleaning features disposed on a clamp engaging surface of the body;
   using a first clamping force to engage the body with the clamp;
   performing an oscillatory movement of the clamp with the first clamping force applied,
   wherein the first clamping force substantially prevents relative movement between the cleaning features and the clamp; and
   changing the clamping force from the first clamping force to a second clamping force,
   wherein the second clamping force is weaker than the first clamping force, so that relative movement between the cleaning features and the clamp occurs in response to the oscillatory movement.
17. The method according to clause 16, wherein the oscillatory movement comprises bi-directional movements along a linear path.
18. The method according to clause 17, wherein a movement along the linear path is in a scan direction.
19. The method according to any of clauses 16 to 18, wherein:
   the clamp is an electrostatic clamp;
   the first clamping force is generated by the electrostatic clamp applying a first clamping voltage; and
   the second clamping force is generated by the electrostatic clamp applying a second clamping voltage.
20. The method according to clause 19, wherein the first clamping voltage is in the range of about 800V to 1000V.
21. The method according to clause 19 or 20, wherein the second clamping voltage is in the range of about 500V to 800V.
22. The method according to any of clauses 16 to 21, wherein the relative movement is over distances in a range from about 20µm to about 2000µm, is preferably in the range of about 300µm to 500µm, and may be about 400µm.
23. The method according to any of clauses 16 to 22, wherein performing the oscillatory movement comprises moving the clamp with a frequency in the range of about 5Hz to 500Hz, preferably in the range of about 100Hz to 300Hz, and more preferably about 200Hz.
24. The method according to any of clauses 16 to 23, further comprising:
   monitoring a servo current of a movement system of the clamp; and
   determining the second clamping force in dependence on the servo current.
25. The method according to clause 24, when dependent on clause 19, wherein changing the clamping force from the first clamping force to the second clamping force comprises:
   determining the servo current when the first clamping voltage is applied and the oscillatory movement is performed;
   monitoring the servo current when the oscillatory movement is performed and the clamping voltage is reduced from the first clamping voltage; and
   determining the second clamping voltage when a predetermined change in the servo current has occurred.
26. The method according to any of clauses 16 to 25, further comprising using one or more sensors to monitor the location of the body; and
   determining if an unintended movement of body has occurred in dependence of the monitoring.
27. The method according to clause 26, wherein the one or more sensors are transmission image sensors.
28. The method according to any of clauses 16 to 27, wherein locations and spacing of the cleaning features on the clamp engaging surface approximate locations and spacing of the end surfaces of burls on the clamp.
29. The method according to any of clauses 16 to 28, further comprising:
   selecting one of a plurality of pre-determined movement profiles of the clamp; and
   controlling the movement system in dependence on the selected movement profile.

The concepts disclosed herein may be associated with any generic imaging system for imaging sub wavelength features, and may be especially useful with emerging imaging technologies capable of producing increasingly shorter wavelengths. Emerging technologies already in use include EUV (extreme ultra violet), DUV lithography that is capable of producing a 193nm wavelength with the use of an ArF laser, and even a 157nm wavelength with the use of a Fluorine laser. Moreover, EUV lithography is capable of producing wavelengths within a range of 20-5nm by using a synchrotron or by hitting a material (either solid or a plasma) with high energy electrons in order to produce photons within this range.

While the concepts disclosed herein may be used for wafer manufacturing on a substrate such as a silicon wafer, it shall be understood that the disclosed concepts may be used with any type of manufacturing system, e.g., those used for manufacturing on substrates other than silicon wafers. In addition, the combination and sub-combinations of disclosed elements may comprise separate embodiments. For example, the cleaning system, and the associated lithography apparatus may comprise separate embodiments, and/or these features may be used together in the same embodiment.

The descriptions above are intended to be illustrative, not limiting. Thus, it will be apparent to one skilled in the art that modifications may be made as described without departing from the scope of the claims set out below.

## Claims

1. A system for in-situ cleaning of a clamp of a lithography apparatus, the system comprising:
a body configured to be inserted into the lithography apparatus and engaged with a clamp, wherein cleaning features are arranged on a clamp facing surface of the body;
a movement system of the clamp; and
a control system;
wherein the control system is configured to:
control the clamp to use a first clamping force to engage the body with the clamp;
control the movement system to move the clamp in an oscillatory movement with the first clamping force applied, wherein the first clamping force substantially prevents relative movement between the cleaning features and the clamp; and
control the clamp to change the clamping force from the first clamping force to a second clamping force, wherein the second clamping force is weaker than the first clamping force, so that relative movement between the cleaning features and the clamp occurs in response to the oscillatory movement.

2. The system according to claim 1, wherein the oscillatory movement comprises bi-directional movements along a linear path.

3. The system according to claim 2, wherein a movement along the linear path is in a scan direction.

4. The system according to any preceding claim, wherein:
the clamp is an electrostatic clamp;
the clamp is configured to generate the first clamping force by applying a first clamping voltage; and
the clamp is configured to generate the second clamping force by applying a second clamping voltage.

5. The system according to claim 4, wherein the first clamping voltage is in the range of about 800V to 1000V.

6. The system according to claim 4 or 5, wherein the second clamping voltage is in the range of about 500V to 800V.

7. The system according to any preceding claim, wherein the relative movement is over distances in a range from about 20µm to about 2000µm, is preferably in the range of about 300µm to 500µm, and may be about 400µm.

8. The system according to any preceding claim, wherein the oscillatory movement comprises a movement frequency in the range of about 5Hz to 500Hz, preferably in the range of about 100Hz to 300Hz, and more preferably about 200Hz.

9. The system according to any preceding claim, wherein the movement system further comprises one or more servos; and
the control system is configured to:
monitor a servo current, wherein the servo current is dependent on the current(s) in the one or more servos; and
determine the second clamping force in dependence on the servo current.

10. The system according to claim 9, when dependent on claim 4, wherein changing the clamping force from the first clamping force to the second clamping force comprises the control system:
determining the servo current when the first clamping voltage is applied and the oscillatory movement is performed;
monitoring the servo current when the oscillatory movement is performed and the clamping voltage is reduced from the first clamping voltage; and
determining the second clamping voltage when a predetermined change in the servo current has occurred.

11. The system according to any preceding claim, further comprising one or more sensors arranged to determine the location of the body;
wherein the control system is configured to:
monitor the location of the body using determined locations by the one or more sensors; and
determine if an unintended movement of body has occurred in dependence of the monitoring.

12. The system according to claim 11, wherein the one or more sensors are transmission image sensors.

13. The system according to any preceding claim, wherein:
the clamp comprises reticle contact areas;
the reticle contact areas comprise end surfaces of burls; and
the locations of the cleaning features on the clamp facing surface correspond to the end surfaces of the burls.

14. The system according to any preceding claim, wherein the control system is configured to:
select one of a plurality of pre-determined movement profiles of the clamp; and
control the movement system in dependence on the selected movement profile.

15. A lithographic apparatus comprising the system according to any preceding claim.

16. A method for in-situ cleaning of a clamp of a lithography apparatus, the method comprising:
inserting a body into the lithography apparatus, the body comprising cleaning features disposed on a clamp engaging surface of the body;
using a first clamping force to engage the body with the clamp;
performing an oscillatory movement of the clamp with the first clamping force applied, wherein the first clamping force substantially prevents relative movement between the cleaning features and the clamp; and
changing the clamping force from the first clamping force to a second clamping force, wherein the second clamping force is weaker than the first clamping force, so that relative movement between the cleaning features and the clamp occurs in response to the oscillatory movement.

17. The method according to claim 16, wherein the oscillatory movement comprises bi-directional movements along a linear path.

18. The method according to claim 17, wherein a movement along the linear path is in a scan direction.

19. The method according to any of claims 16 to 18, wherein:
the clamp is an electrostatic clamp;
the first clamping force is generated by the electrostatic clamp applying a first clamping voltage; and
the second clamping force is generated by the electrostatic clamp applying a second clamping voltage.

20. The method according to claim 19, wherein the first clamping voltage is in the range of about 800V to 1000V.

21. The method according to claim 19 or 20, wherein the second clamping voltage is in the range of about 500V to 800V.

22. The method according to any of claims 16 to 21, wherein the relative movement is over distances in a range from about 20µm to about 2000µm, is preferably in the range of about 300µm to 500µm, and may be about 400µm.

23. The method according to any of claims 16 to 22, wherein performing the oscillatory movement comprises moving the clamp with a frequency in the range of about 5Hz to 500Hz, preferably in the range of about 100Hz to 300Hz, and more preferably about 200Hz.

24. The method according to any of claims 16 to 23, further comprising:
monitoring a servo current of a movement system of the clamp; and determining the second clamping force in dependence on the servo current.

25. The method according to claim 24, when dependent on claim 19, wherein changing the clamping force from the first clamping force to the second clamping force comprises:
determining the servo current when the first clamping voltage is applied and the oscillatory movement is performed;
monitoring the servo current when the oscillatory movement is performed and the clamping voltage is reduced from the first clamping voltage; and
determining the second clamping voltage when a predetermined change in the servo current has occurred.

26. The method according to any of claims 16 to 25, further comprising using one or more sensors to monitor the location of the body; and
determining if an unintended movement of body has occurred in dependence of the monitoring.

27. The method according to claim 26, wherein the one or more sensors are transmission image sensors.

28. The method according to any of claims 16 to 27, wherein locations and spacing of the cleaning features on the clamp engaging surface approximate locations and spacing of the end surfaces of burls on the clamp.

29. The method according to any of claims 16 to 28, further comprising:
selecting one of a plurality of pre-determined movement profiles of the clamp; and
controlling the movement system in dependence on the selected movement profile.
